# EUROPEAN PATENT SPECIFICATION

(11) **EP 3 678 192 B1**
(45) Date of publication and mention of the grant of the patent: **30.03.2022**
(21) Application number: 18850270.2
(22) Date of filing: 24.08.2018
(51) Int. Cl.: H01L 31/0224, H01L 31/068

(54) **SOLAR CELL ELEMENT AND SOLAR CELL MODULE**
SOLARZELLENELEMENT UND SOLARZELLENMODUL
ÉLÉMENT DE PHOTOPILE ET MODULE DE PHOTOPILE

(30) Priority: 29.08.2017 JP 2017164650
(43) Date of publication of application: 08.07.2020
(73) Proprietor: KYOCERA Corporation, Kyoto 612-8501 (JP)
(72) Inventor: YONEKURA, Norihiro, Kyoto-shi Kyoto 612-8501 (JP); AMANO, Yoshiyuki, Kyoto-shi Kyoto 612-8501 (JP); OSHIDA, Takao, Kyoto-shi Kyoto 612-8501 (JP); SUZUKI, Keita, Kyoto-shi Kyoto 612-8501 (JP)
(74) Representative: Viering, Jentschura & Partner mbB Patent- und Rechtsanwälte
(86) International application number: PCT/JP2018/031274
(87) International publication number: WO 2019/044676

(56) References cited:
- EP-A1- 2 757 595
- JP-A- 2012 507 165
- JP-A- 2014 053 287
- JP-U- 3 201 088
- US-A1- 2013 337 604

## Description

### Technical Field

The present disclosure relates to a solar cell element and a solar cell module.

### Background Art

Solar cell elements include passivated emitter and rear cell (PERC) type solar cell elements (see, for example, descriptions in Japanese Translation of PCT International Application Publication No. 2013-526045, Japanese Patent Application Laid-Open No. 2014-53287, Japanese Patent Application Laid-Open No. 2017-45907, and PCT International Publication No. 2009/157079).

Such a PERC type solar cell element, for example, has a back electrode and a back surface of a semiconductor substrate that are connected to each other via a large number of through electrodes formed through a passivation layer positioned on the back surface side of the semiconductor substrate. For example, there is a structure in which a large number of through electrodes are evenly arranged over the entire surface of the passivation layer (see, for example, descriptions in Japanese Translation of PCT International Application Publication No. 2013-526045 and Japanese Patent Application Laid-Open No. 2014-53287). Furthermore, for example, there is a structure in which a large number of through electrodes are evenly arranged over the entire surface of the passivation layer excluding a bus bar electrode on the back surface side (see, for example, descriptions in Japanese Patent Application Laid-Open No. 2017-45907 and PCT International Publication No. 2009/157079). US 2013/337604 A1 discloses a solar cell of the PERC (Passivated Emitter and Rear Cell) type comprising on its rear surface a back-side bus electrode and an aluminium electrode electrically contacting each other.

### Summary

The invention provides a solar cell element according to claim 1. A solar cell element and a solar cell module are disclosed.

One aspect of a solar cell element includes a semiconductor substrate, a passivation layer, a plurality of through electrodes, a first electrode, and one or more second electrodes. The semiconductor substrate has a first surface and a second surface positioned to face in a direction opposite to a direction of the first surface. The passivation layer is positioned on the second surface and has a plurality of holes. The plurality of through electrodes are positioned in the plurality of holes while being electrically connected to the second surface of the semiconductor substrate. The first electrode is positioned on the passivation layer while being electrically connected to two or more first through electrodes in the plurality of through electrodes. The one or more second electrodes are positioned to linearly extend in a first direction on the passivation layer while being electrically connected to one or more second through electrodes in the plurality of through electrodes, and are electrically connected to the first electrode. When the first electrode and the second electrode are seen in plane perspective view, a ratio of an area occupied by the one or more second through electrodes in a second region in which the second electrode is positioned is smaller than a ratio of an area occupied by the two or more first through electrodes in a first region in which the first electrode is positioned.

One aspect of a solar cell module includes a plurality of solar cell elements according to the above-described aspect, a plurality of wiring members, a first member, a second member, a first filler, and a second filler. The plurality of solar cell elements are positioned to be arranged two dimensionally. The plurality of wiring members are positioned in a state of electrically connecting adjacent solar cell elements in the plurality of solar cell elements. The first member is positioned on the first surface side of the plurality of solar cell elements and has translucency. The second member is positioned on the second surface side of the plurality of solar cell elements. The first filler is positioned between the plurality of solar cell elements and the first member and has translucency. The second filler is positioned between the plurality of solar cell elements and the second member.

### Brief Description of Drawings

Fig. 1 is a plan view showing an appearance on a first member side of one example of a solar cell module according to a first embodiment.
Fig. 2(a) is a cross-sectional view showing an example of a cut section of the solar cell module taken along line II-II in Fig. 1. Fig. 2(b) is a cross-sectional view showing another example of a cut section of the solar cell module taken along line II-II in Fig. 1.
Fig. 3 is a plan view showing an appearance on a first element surface side of an example of a solar cell element according to the first embodiment.
Fig. 4 is a plan view showing an appearance on a second element surface side of an example of the solar cell element according to the first embodiment.
Fig. 5 is a diagram showing an example of a virtual cut surface portion of the solar cell element taken along line V-V in Figs. 3 and 4.
Fig. 6(a) is an enlarged plan view showing an enlarged appearance on the second element surface side of the solar cell element in a VIa portion of Fig. 4. Fig. 6(b) is an enlarged plan view showing an enlarged configuration of a passivation layer in the VIa portion of Fig. 4.
Fig. 7 is a diagram showing an example of a virtual cut surface portion of the solar cell element taken along line VII-VII in Fig. 6(a).
Fig. 8 is a diagram showing an example of a virtual cut surface portion of a solar cell element according to Reference Example, corresponding to the virtual cut surface portion taken along line VII-VII in Fig. 6(a).
Fig. 9(a) to Fig. 9(f) are each a diagram showing an example of a virtual cut surface portion, corresponding to the virtual cut surface portion shown in Fig. 5, in an intermediate state of manufacturing of the solar cell element according to the first embodiment.
Fig. 10 is a diagram showing a schematic configuration of an apparatus for measuring a breaking load of a solar cell element.
Fig. 11 is a graph showing an example of measurement results of the breaking load of the solar cell element.
Fig. 12 is a diagram showing an example of a virtual cut surface portion of a solar cell element according to a second embodiment, corresponding to the virtual cut surface portion taken along line VII-VII in Fig. 6(a).
Fig. 13 is a diagram showing an example of a virtual cut surface portion of a solar cell element according to a third embodiment, corresponding to the virtual cut surface portion taken along line VII-VII in Fig. 6(a).

### Description of Embodiments

In a PERC type solar cell element, for example, output characteristics are improved by passivation effect provided by a passivation layer positioned on the back surface side of a semiconductor substrate. In this passivation layer, a large number of through electrodes are positioned while being in a state of electrically connecting the back surface of the semiconductor substrate and a back electrode to each other, and carriers obtained by photoelectric conversion are collected on the back surface side of the semiconductor substrate. The back electrode includes, for example, an electrode for collecting carriers (also referred to as a collecting electrode) and a bus bar electrode in a state of being electrically connected to the collecting electrode for extracting an output.

Here, for example, the passivation effect can be enhanced by making an area including the through electrodes smaller and making an area including the passivation layer larger. On the other hand, for example, the efficiency of collecting carriers obtained by the photoelectric conversion in the semiconductor substrate (also referred to as collection efficiency) can be enhanced by making the region including the through electrodes larger and making the region including the passivation layer smaller. Thus, for example, the output characteristics of the PERC type solar cell element may be improved by adjusting the number and the size of the through electrodes as appropriate while taking the balance between the passivation effect and the collection efficiency into consideration.

Meanwhile, for example, when the through electrodes are positioned immediately below the bus bar electrode in plane perspective view, in such a portion, the passivation layer is reduced and recombination of minority carriers is likely to occur. In this case, for example, the photoelectric conversion efficiency in the PERC type solar cell element may be compromised. However, for example, when the through electrodes connected to the bus bar electrode are not positioned immediately below the bus bar electrode in plane perspective view, the joining strength of the bus bar electrode to the semiconductor substrate is low, meaning that the bus bar electrode is likely to be peeled off from the semiconductor substrate. In this case, for example, long-term reliability of the PERC type solar cell element may be compromised.

All things considered, the inventors of the present application have developed a technology that can improve the photoelectric conversion efficiency and the long-term reliability in a well-balanced manner for PERC type solar cell elements and solar cell modules.

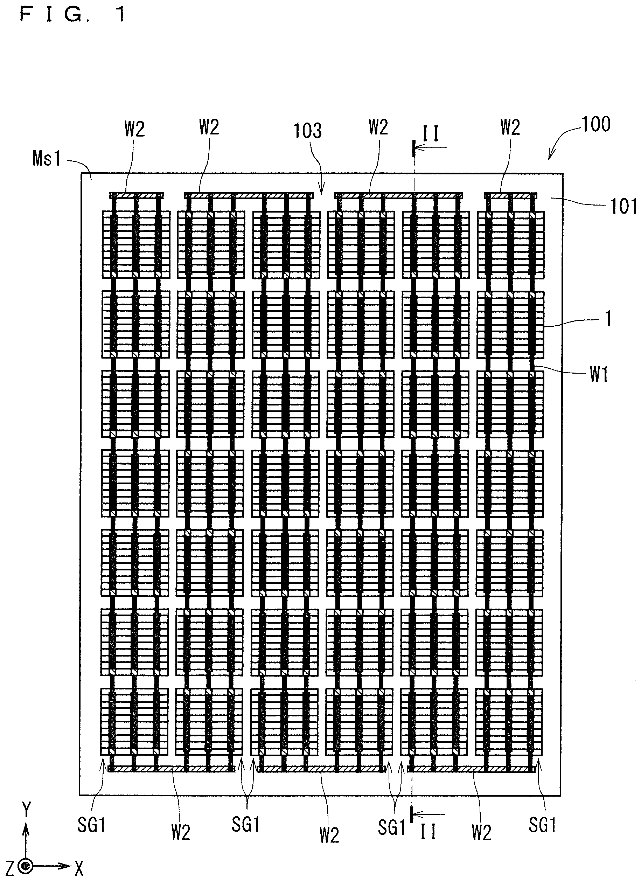

Various embodiments regarding this will be described below with reference to the drawings. The same reference signs are allocated to components having similar structures and functions in the drawings, and the description thereof will not be repeated below. The drawings are shown schematically. Figs. 1 to 10 and Figs. 12 and 13 each show a right-hand XYZ coordinate system. In this XYZ coordinate system, a short direction of a first output extracting electrode E11 along a first element surface 1fs of a solar cell element 1 is a +X direction, a longitudinal direction of the first output extracting electrode E11 along the first element surface 1fs is a +Y direction, and a direction orthogonal to both the +X direction and the +Y direction is a +Z direction.

### < 1. First Embodiment>

### <1-1. Solar Cell Module>

The configuration of a solar cell module 100 according to a first embodiment will be described with reference to Figs. 1 to 7.

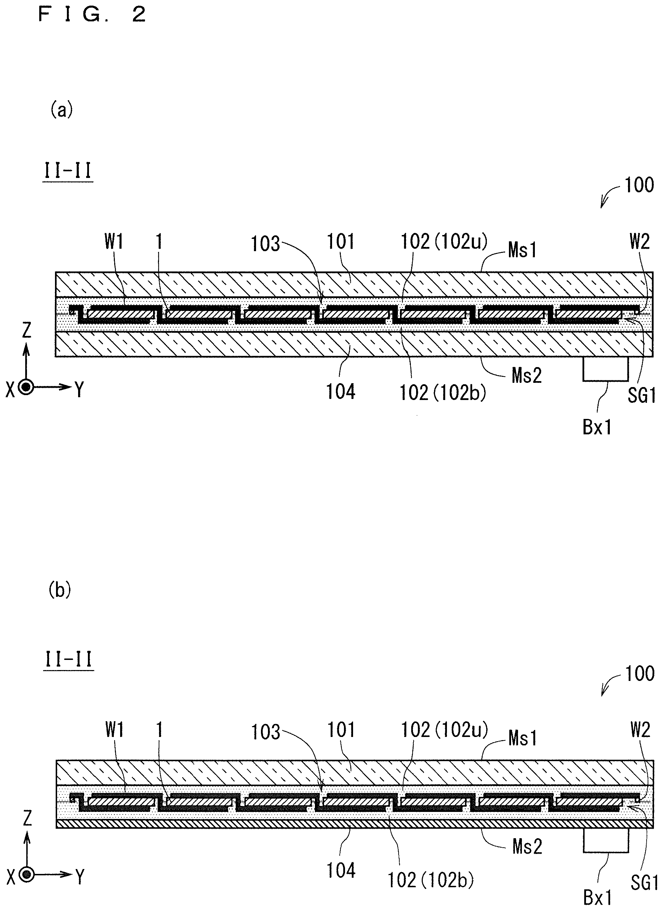

As shown in Figs. 1 and 2(a), the solar cell module 100 includes, for example, a first member 101, a filler 102, a solar cell unit 103, and a second member 104. The filler 102 includes, for example, a first filler 102u and a second filler 102b. In the example shown in Figs. 1 and 2(a), the solar cell module 100 has a configuration in which the first member 101, the first filler 102u, the solar cell unit 103, the second filler 102b, and the second member 104 are stacked in this order in a -Z direction. For example, the solar cell module 100 has a front surface (also referred to as a first module surface) Ms1 mainly arranged toward a light source such as the sun and a back surface (also referred to as a second module surface) Ms2 positioned while facing in a direction opposite to that of the first module surface Ms 1.

The solar cell unit 103 includes, for example, a plurality of the solar cell elements 1, a plurality of first wiring members W1, and a plurality of second wiring members W2. In the example shown in Fig. 1, in the solar cell unit 103, for example, the plurality of solar cell elements 1 are positioned to be arranged two dimensionally. Specifically, the solar cell unit 103 includes, for example, a plurality of (six in this case) solar cell strings SG1. The solar cell strings SG1 each include, for example, a plurality of (seven in this case) the solar cell elements 1 and a plurality of the first wiring members W1. For example, the plurality of first wiring members W1 are positioned in a state of electrically connecting the adjacent ones of the solar cell elements 1 to each other. For example, the plurality of second wiring members W2 are positioned in a state of electrically connecting the adjacent ones of the solar cell strings SG1 to each other. Each of the solar cell elements 1 has a surface (also referred to as a first element surface) 1fs positioned on a front surface side and a surface (also referred to as a second element surface) 1bs positioned while facing in a direction opposite to that of the first element surface 1fs. In the example in Figs. 1 to 5, the first element surface 1fs faces in the +Z direction, and the second element surface 1bs faces in the -Z direction.

For example, the first member 101 is positioned on the first element surface 1fs side of the solar cell unit 103 including the plurality of solar cell elements 1. For example, the first member 101 can function to protect the solar cell unit 103 and to seal the solar cell unit 103. The first member 101 may be formed of a transparent material, for example. The first member 101 may be formed of glass or may be formed of a resin such as an acrylic or polycarbonate resin or the like, for example. Thus, the first member 101 can have translucency with respect to light of a wavelength in a specific range, for example. Examples of the wavelength in the specific range used include a wavelength of light that has high intensity included in light with which the solar cell module 100 is irradiated and that can be photoelectrically converted by the solar cell unit 103. Here, the glass may be a material having a high light transmittance, for example. Furthermore, examples of the glass used may include white plate glass, tempered glass, or heat ray reflective glass. For example, the glass may have a thickness of about 2 mm to 5 mm. As the shape of the first member 101, for example, a plate shape such as a flat plate shape may be employed. In the example in Figs. 1 and 2(a), when the first member 101 is viewed in plan view from the +Z direction side in the -Z direction, the outer shape of the first member 101 is rectangular. As the surface on the +Z direction side of the first member 101, for example, a rectangular surface with each side being about 900 mm to 1200 mm long may be employed.

For example, the second member 104 is positioned on the second element surface 1bs side of the solar cell unit 103 including the plurality of solar cell elements 1. For example, the second member 104 can function to protect the solar cell unit 103 and to seal the solar cell unit 103. The material, shape, and thickness of the second member 104 may be the same as those of the first member 101, for example. For example, similarly to the first member 101, the second member 104 has translucency with respect to light of a wavelength in a specific range. Here, for example, the second member 104 may not have translucency with respect to light of a wavelength in a specific range. In this case, the second member 104 may be a sheet-like member (also referred to as a back sheet) such as a resin as shown in Fig. 2(b), for example. Furthermore, for example, as the second member 104, a weather-resistant fluorine-based resin sheet sandwiching aluminum foil having a white surface, a polyethylene terephthalate (PET) sheet on which alumina or silica is deposited or the like may be used.

For example, the first filler 102u is positioned between the plurality of solar cell elements 1 and the first member 101. For example, the second filler 102b is positioned between the plurality of solar cell elements 1 and the second member 104. In other words, the filler 102 including the first filler 102u and the second filler 102b is positioned while filling between the first member 101 and the second member 104 so as to cover the solar cell unit 103, for example. Thus, for example, the first filler 102u and the second filler 102b can function to hold the solar cell unit 103 and function as a sealing material for sealing the solar cell unit 103. Similarly to the first member 101 and the second member 104, the first filler 102u and the second filler 102b have translucency. Examples of materials used for the first filler 102u and the second filler 102b include thermosetting resin and the like. The thermosetting resin may contain an ethylene vinyl acetate copolymer (EVA) or polyvinyl butyral (PVB) as a main component, for example. The thermosetting resin may contain a crosslinking agent, for example. In the present specification, the main component means a component contained in the largest (highest) ratio (also referred to as content ratio) among the components contained. Here, for example, the second filler 102b may not have translucency with respect to light of a wavelength in a specific range. For example, a colored resin material may be used as the second filler 102b. For example, EVA that is colored in white by adding titanium oxide or the like may be used as the second filler 102b.

### <1-2. Configuration of Solar Cell Element>

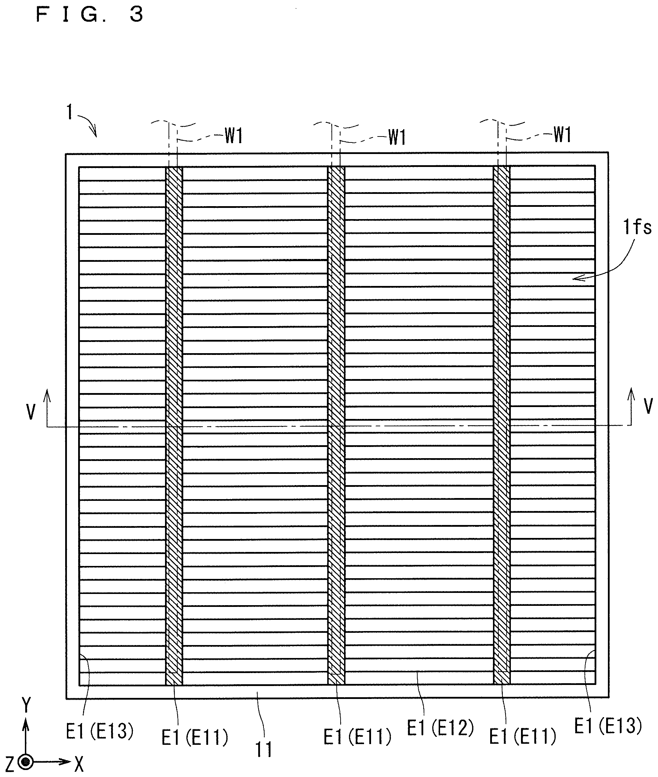

The configuration of the solar cell element 1 according to the first embodiment will be described with reference to Figs. 3 to 7. The solar cell element 1 according to the first embodiment is a PERC type solar cell element.

For example, the solar cell element 1 includes a semiconductor substrate 10, an antireflection film 11, a passivation layer 12, a protective layer 13, a front electrode E1, and a back electrode E2.

The semiconductor substrate 10 has a first surface 10fs and a second surface lObs positioned while facing in a direction opposite to that of the first surface 10fs. The first surface 10fs is positioned on the first element surface 1fs side of the solar cell element 1. In the example in Figs. 3 to 5, the first surface 10fs is in a state of facing in the +Z direction. The second surface lObs is positioned on the second element surface 1bs side of the solar cell element 1. In the example in Figs. 3 to 5, the second surface lObs is in a state of facing in the -Z direction. The first surface 10fs and the second surface lObs each form a plate surface of the semiconductor substrate 10 along the XY plane. The semiconductor substrate 10 has a thickness along the +Z direction.

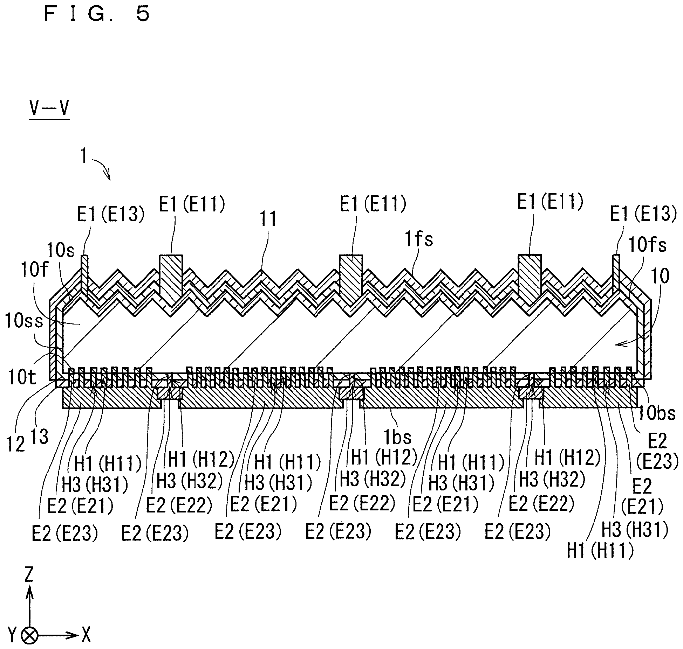

The semiconductor substrate 10 further includes a first semiconductor region 10f and a second semiconductor region 10s, for example. The first semiconductor region 10f is positioned, for example, on the second surface lObs side of the semiconductor substrate 10. The first semiconductor region 10f is, for example, a region formed by a semiconductor of a first conductivity type. The second semiconductor region 10s is positioned, for example, on the first surface 10fs side of the semiconductor substrate 10. The second semiconductor region 10s is, for example, a region formed by a semiconductor of a second conductivity type opposite to the first conductivity type. In the example in Fig. 5, the second semiconductor region 10s is positioned in a surface layer part on the first surface 10fs side of the semiconductor substrate 10. In other words, the second semiconductor region 10s is positioned on the first semiconductor region lOf.

Here, for example, the semiconductor substrate 10 is assumed to be a silicon substrate containing silicon. In this case, a polycrystalline or monocrystalline silicon substrate is employed as the silicon substrate. The silicon substrate is, for example, a thin substrate having a thickness of 250 µm or less or 150 µm or less. Furthermore, the silicon substrate has, for example, a substantially rectangular plate surface having each side being about 150 mm to 200 mm long in plan view. When the semiconductor substrate 10 having such a shape is employed, the solar cell module 100 may be manufactured by arranging a plurality of the solar cell elements 1 with a small gap between the solar cell elements 1.

For example, when the first conductivity type is p-type and the second conductivity type is n-type, the p-type silicon substrate may be produced by, for example, providing impurities such as boron or gallium serving as dopant elements into polycrystalline or monocrystalline silicon crystals. In this case, the n-type second semiconductor region 10s may be produced with impurities such as phosphorus serving as a dopant dispersed in the surface layer part on the first surface 10fs side of the p-type silicon substrate. As a result, the semiconductor substrate 10 in which the p-type first semiconductor region 10f and the n-type second semiconductor region 10s are stacked may be formed. Thus, the semiconductor substrate 10 has a pn junction positioned at the interface between the first semiconductor region 10f and the second semiconductor region 10s.

As shown in Fig. 5, the first surface 10fs of the semiconductor substrate 10 may have, for example, a structure with micro recesses and protrusions (also referred to as a texture) for reducing the reflectance of irradiation light. The height of each of the protrusions in the texture is, for example, about 0.1 µm to 10 µm. The distance between the apexes of adjacent protrusions of the texture is, for example, about 0.1 µm to 20 µm. In the texture, for example, the recesses may be substantially spherical. In the texture, for example, the protrusions may have a pyramid shape. The "height of each of the protrusions" described above means, for example in Fig. 5, a distance between the apex of each of the protrusions and a reference line that is defined as a straight line passing through the bottoms of the recesses, in a direction perpendicular to the reference line (the +Z direction in this case).

The semiconductor substrate 10 includes a third semiconductor region 10t. The third semiconductor region 10t is positioned in the surface layer part on the second surface lObs side of the semiconductor substrate 10. The conductivity type of the third semiconductor region 10t may only be the same as that of the first semiconductor region 10f (p-type in the first embodiment). The concentration of the dopant contained in the third semiconductor region 10t is higher than the concentration of the dopant contained in the first semiconductor region 10f. With this configuration, the third semiconductor region lOt serves as a back surface field (BSF) layer that forms an internal electric field on the second surface lObs side of the semiconductor substrate 10. Thus, in the vicinity of the second surface lObs of the semiconductor substrate 10, recombination of minority carriers generated by photoelectric conversion in response to light irradiation in the semiconductor substrate 10 may be reduced. As a result, the photoelectric conversion efficiency in the solar cell element 1 is less likely to be compromised. The third semiconductor region 10t can be formed with a dopant element, such as aluminum, diffused in the surface layer part on the second surface lObs side of the semiconductor substrate 10, for example. Here, the concentration of the dopant element contained in the first semiconductor region 10f can be set to about 5 × 10¹⁵ atoms/cm³ to 1 × 10¹⁷ atoms/cm³, and the concentration of the dopant element contained in the third semiconductor region 10t can be set to about 1 × 10¹⁸ atoms/cm³ to 5 × 10²¹ atoms/cm³. The third semiconductor region 10t only needs to be present, for example, at a contact portion between a first through electrode E231 on the back surface side described later and the semiconductor substrate 10.

The antireflection film 11 is, for example, positioned on the first surface 10fs side of the semiconductor substrate 10. The antireflection film 11 can, for example, reduce the reflectance of light with which the first element surface 1fs of the solar cell element 1 is irradiated. As the material of the antireflection film 11, for example, silicon oxide, aluminum oxide, silicon nitride, or the like may be adopted. The refractive index and the thickness of the antireflection film 11 may be set as appropriate to be values satisfying a condition achieving low reflectance (also referred to as a low reflection condition) of light of sunlight whose wavelength range can contribute to electric power generation through absorption into the semiconductor substrate 10 for example. Here, for example, the refractive index of the antireflection film 11 is about 1.8 to 2.5, and the thickness of the antireflection film 11 is about 50 nm to 120 nm. The antireflection film 11 can be formed by using plasma CVD (plasma-enhanced chemical vapor deposition (PECVD)) or sputtering.

The passivation layer 12 is positioned on at least the second surface lObs of the semiconductor substrate 10. In the first embodiment, the passivation layer 12 is positioned in a state of being in contact with the second surface lObs of the semiconductor substrate 10. For example, the passivation layer 12 can reduce recombination of minority carriers generated by photoelectric conversion in response to light irradiation in the semiconductor substrate 10. As the material of the passivation layer 12, for example, aluminum oxide or the like is adopted. In this case, the passivation layer 12 may be formed by, for example, atomic layer deposition (ALD). Here, aluminum oxide has negative fixed charge. Thus, minority carriers (electrons in this case) generated on the second surface lObs side of the semiconductor substrate 10 are separated from the interface (second surface lObs) between the p-type first semiconductor region lOf and the passivation layer 12 by the field effect. Thus, the recombination of minority carriers can be reduced in the vicinity of the second surface lObs in the semiconductor substrate 10. As a result, the photoelectric conversion efficiency in the PERC type solar cell element 1 can be improved. The thickness of the passivation layer 12 is, for example, about 10 nm to 60 nm. The passivation layer 12 may also be positioned on the first surface 10fs of the semiconductor substrate 10, for example. The passivation layer 12 may be positioned, for example, on a side surface lOss in a state of connecting the first surface 10fs and the second surface lObs of the semiconductor substrate 10 to each other.

Here, the passivation layer 12 has, for example, a plurality of holes (also referred to as first holes) H1. Each of the first holes H1 is positioned while being formed through the passivation layer 12 in the thickness direction of the passivation layer 12 (here, the +Z direction). The first holes H1 may each be, for example, a hole having a form of a through hole having a circumference along the second surface lObs closed. Furthermore, the first holes H1 may each be a hole having a slit-like form with at least a part of the circumference along the second surface lObs open. Here, the plurality of first holes H1 include, for example, first A holes H11 positioned immediately below a second collecting electrode E21 described later and first B holes H12 positioned immediately below a second output extracting electrode E22 described later.

The protective layer 13 is, for example, positioned on the second surface lObs side of the semiconductor substrate 10. In the first embodiment, the protective layer 13 is, for example, positioned on the passivation layer 12 positioned on the second surface lObs of the semiconductor substrate 10. In other words, the protective layer 13 is, for example, positioned between the passivation layer 12 and the back electrode E2. The protective layer 13 is on the passivation layer 12 to cover the passivation layer 12. Thus, the protective layer 13 can protect the passivation layer 12, for example. Specifically, for example, moisture and the like are less likely to reach the passivation layer 12 from the outside of the solar cell element 1 due to the presence of the protective layer 13, in both of situations where the solar cell element 1 is manufactured and the solar cell element 1 is used. Thus, the passivation layer 12 is less likely to deteriorate.

As the material of the protective layer 13, for example, silicon oxide, silicon nitride, insulating resin, or the like is adopted. The protective layer 13 is positioned on the passivation layer 12, in a state having a desired pattern. The protective layer 13 has a plurality of holes (also referred to as second holes) H3 in a state of being formed through the protective layer 13 in the thickness direction (here, the +Z direction). The second holes H3 may each be, for example, a hole having a form of a through hole having a circumference along the second surface lObs closed. Furthermore, the second holes H3 may each be a hole having a slit-like form with at least a part of the circumference along the second surface lObs open. Each of the second holes H3 is, for example, in a state of being continuously connected to the corresponding first hole H1 of the passivation layer 12. Here, the plurality of second holes H3 include, for example, second A holes H31 positioned immediately below the second collecting electrode E21 described later and second B holes H32 positioned immediately below the second output extracting electrode E22 described later.

The protective layer 13 is formed, for example, on the passivation layer 12 formed on the second surface lObs of the semiconductor substrate 10, by a dry process or a wet process. For example, a method of applying, drying and heating insulating paste or the like is adopted for the wet process. For example, a method using PECVD, sputtering, and the like is adopted for the dry process.

Here, for example, if the protective layer 13 is a thin film containing silicon nitride, the protective layer 13 can be formed using a dry process such as sputtering or chemical vapor deposition. Thus, for example, the joining strength between the passivation layer 12 and the protective layer 13 can be improved. In this case, for example, the second holes H3 having a desired pattern can be formed by emitting a laser beam, using a laser apparatus, on the second surface lObs side of the semiconductor substrate 10. For example, a neodymium doped, yttrium/aluminum/garnet (Nd:YAG) laser with a Q switch is adopted for the laser apparatus. In this case, for example, the second holes H3 having a desired pattern may be formed by using a mask on the second surface lObs side of the semiconductor substrate 10. Here, when the second holes H3 are formed in the protective layer 13, the first holes H1 can be formed in the passivation layer 12 at the same time.

Furthermore, for example, if the protective layer 13 is a thin film containing siloxane resin or the like, the protective layer 13 can be formed using a wet process in which insulating paste is applied to the passivation layer 12 by a screen printing method, dried and the like. Here, for the insulating paste, for example, insulating paste including siloxane resin that is a raw material of the protective layer 13, an organic solvent, and a plurality of fillers is adopted. Siloxane resin is a siloxane compound having a Si-O-Si bond (also referred to as a siloxane bond). Specifically, as the siloxane resin, for example, a low molecular weight resin having a molecular weight of 15,000 or less, which is produced by hydrolysis and condensation polymerization of alkoxysilane, silazane, or the like is adopted.

The protective layer 13 may be formed on the side surface lOss of the semiconductor substrate 10, for example. In this case, the solar cell element 1 is less likely to involve leak current due to the presence of the protective layer 13.

The front electrode E1 is positioned on the first surface 10fs side of the semiconductor substrate 10. The front electrode E1 includes the first output extracting electrode E11 and the first collecting electrode E12.

The first output extracting electrode E11 is an electrode (also referred to as a bus bar electrode) that can collect carriers, generated by photoelectric conversion in response to light irradiation in the semiconductor substrate 10, via the first collecting electrode E12 and extract electricity to the outside of the solar cell element 1. In the example in Figs. 3 and 5, three first output extracting electrodes E11 are provided on the first surface 10fs side of the semiconductor substrate 10. Each of the first output extracting electrodes E11 has a longitudinal direction along the first surface 10fs. This longitudinal direction is the +Y direction. Each of the first output extracting electrodes E11 has a short direction (also referred to as a width direction) intersecting the longitudinal direction. The width direction is the +X direction. Here, the first output extracting electrode E11 has, for example, an elongated rectangular shape in plan view. The length in the short direction (also referred to as a width) of the first output extracting electrode E11 is, for example, about 0.8 mm to 2 mm. At least a part of the first output extracting electrode E11 is in a state of intersecting and being electrically connected to the first collecting electrode E12.

The first collecting electrode E12 is an electrode that can collect carriers generated by photoelectric conversion in response to light irradiation in the semiconductor substrate 10. In the example in Fig. 3, a plurality of the first collecting electrodes E12 are provided on the first surface 10fs side of the semiconductor substrate 10. Each of the first collecting electrodes E12 has a longitudinal direction along the first surface 10fs. This longitudinal direction is the +X direction. Each of the first collecting electrodes E12 has a short direction (also referred to as a width direction) intersecting the longitudinal direction. Here, each of the first collecting electrodes E12 is, for example, a linear electrode. Each of the first collecting electrodes E12 has a width of about 30 µm to 150 µm, for example. Thus, the width of each of the first collecting electrodes E12 is smaller than the width of the first output extracting electrode E11. Furthermore, the plurality of first collecting electrodes E12 are positioned to be arranged with a space of about 1 mm to 3 mm therebetween, for example.

The thickness of the first output extracting electrode E11 and the first collecting electrode E12 is, for example, about 10 µm to 40 µm. The first output extracting electrode E11 and the first collecting electrode E12 can be formed, for example, by applying silver paste into a desired shape by screen printing or the like and then firing the silver paste. For example, the silver paste may only be conductive paste containing metal powder containing silver as a main component, an organic vehicle, and glass frits. Furthermore, the front electrode E1 includes, for example, an auxiliary electrode E13. The auxiliary electrode E13 is positioned along a circumference edge of the semiconductor substrate 10, and is in a state of electrically connecting the first collecting electrodes E12 to each other. For example, the auxiliary electrode E13 may have the same shape as the first collecting electrode E12 on the first surface 10fs.

The back electrode E2 is positioned on the second surface lObs side of the semiconductor substrate 10. The back electrode E2 includes a first electrode (also referred to as a second collecting electrode) E21, one or more second electrodes (also referred to as second output extracting electrodes) E22, and a plurality of through electrodes E23.

Each of the plurality of through electrodes E23 is positioned while being electrically connected to the second surface lObs of the semiconductor substrate 10, in a continuous hole (also referred to as a connected hole) including the first hole H1 and the second hole H3 in a state of being continuously connected to each other. The connected hole may be, for example, a hole having a form of a through hole having a circumference along the second surface lObs closed. Furthermore, the connected hole may be, for example, a hole having a slit-like form with at least a part of the circumference along the second surface lObs open. As shown in Figs. 5 to 7, the plurality of through electrodes E23 include two or more first through electrodes E231 and one or more second through electrodes E232. The first through electrodes E231 are, for example, positioned while being electrically connected to the second surface lObs of the semiconductor substrate 10, in a continuous hole (also referred to as a first connected hole) including the first A hole H11 and the second A hole H31 in a state of being continuously connected to each other. The second through electrodes E232 is, for example, positioned while being electrically connected to the second surface lObs of the semiconductor substrate 10, in a continuous hole (also referred to as a second connected hole) including the first B hole H12 and the second B hole H32 in a state of being continuously connected to each other.

The second collecting electrode E21 is positioned on the passivation layer 12. The second collecting electrode E21 can, for example, collect carriers generated by photoelectric conversion in response to light irradiation in the semiconductor substrate 10, on the second surface lObs side of the semiconductor substrate 10. As shown in Figs. 5 to 7, the second collecting electrode E21 is positioned on the passivation layer 12 while being electrically connected to the two or more first through electrodes E231. In the example in Figs. 5 to 7, the second collecting electrode E21 is positioned on the protective layer 13, positioned on the passivation layer 12 while being electrically connected to the two or more first through electrodes E231. In other words, in the example in Figs. 5 to 7, the second collecting electrode E21 is, for example, positioned on the passivation layer 12 so that a state where the second collecting electrode E21 and the passivation layer 12 sandwich the protective layer 13 is achieved.

The thickness of the second collecting electrode E21 is, for example, about 15 µm to 50 µm. The second collecting electrode E21 can be formed by applying and firing conductive paste, for example. The application of the conductive paste can be realized by, for example, screen-printing or the like. For example, when the conductive paste is applied on the protective layer 13, the conductive paste may also be applied in the second A holes H31 or in the second A holes H31 and the first A holes H11. Thus, the second collecting electrode E21 and the first through electrodes E231 can be formed simultaneously by firing the conductive paste.

Here, for example, when the second collecting electrode E21 contains aluminum as a main component, conductive paste containing aluminum as a main component (also referred to as aluminum paste) is adopted for the conductive paste for forming the second collecting electrode E21. For example, the aluminum paste contains metal powder containing aluminum as a main component, an organic vehicle, and glass frits. This aluminum paste may be produced, for example, by kneading the metal powder containing aluminum, the glass frits, and the organic vehicle. In this case, about 65% to 80% by mass of the total mass of the aluminum paste is the metal powder containing aluminum, about 0.05% to 10% by mass of the total mass is the organic vehicle, and about 2% to 15% by mass is the glass frits, for example.

Here, the particle size of the metal powder containing aluminum is, for example, about 0.05 µm to 20 µm. The particle size of the metal powder containing aluminum may be, for example, about 0.1 µm to 5 µm. The organic vehicle is prepared, for example, by adding a resin component serving as a binder to an organic solvent. As the binder, for example, a cellulose resin such as ethyl cellulose, an acrylic resin, an alkyd resin, or the like is used. As the organic solvent, for example, diethylene glycol monobutyl ether acetate, terpineol, diethylene glycol monobutyl ether, or the like is used. As the glass frits, for example, lead glass such as Al₂O₃-SiO₂-PbO is adopted.

For example, in a case that the protective layer 13 is formed by the wet process, the aluminum paste directly applied on the passivation layer 12 in the second A holes H31 of the protective layer 13, causes firing through in the passivation layer 12 when the aluminum paste is fired. In this process, the first A holes H11 of the passivation layer 12 may be formed. Furthermore, for example, the first through electrode E231 in a state of being connected to the second collecting electrode E21 and directly connected to the second surface lObs of the semiconductor substrate 10 may be formed. For example, in a case that the protective layer 13 is formed by the dry process, a state where the second A holes H31 and the first A holes H11 are formed by laser irradiation or the like is achieved. Therefore, the aluminum paste is directly applied onto the second surface lObs of the semiconductor substrate 10 in the first connected hole, including the second A hole H31 and the first A hole H11 that are in the state of being continuously connected to each other. Thus, when the aluminum paste is fired, the first through electrode E231 may be formed even without causing the firing through in the passivation layer 12. Furthermore, when the aluminum paste is fired, for example, the third semiconductor region lOt is formed with aluminum, in the aluminum paste, dispersed in the surface layer part of the second surface lObs of the semiconductor substrate 10.

Here, for example, when the thickness of the protective layer 13 is sufficiently larger than the thickness of the passivation layer 12, no firing through of the aluminum paste in the passivation layer 12 occurs in a portion of the passivation layer 12 covered with the protective layer 13. Thus, the passivation layer 12 with a pattern corresponding to the desired pattern of the protective layer 13 can be provided on the second surface lObs of the semiconductor substrate 10 in the solar cell element 1. Here, for example, when the protective layer 13 is formed of silicon nitride by PECVD, the thickness of the protective layer 13 is, for example, about 70 nm to 200 nm. When the protective layer 13 is formed using insulating paste, the thickness of the protective layer 13 is, for example, about 0.5 µm to 10 µm. The thickness of the protective layer 13 in this case is set as appropriate, for example, in accordance with the composition of the insulating paste for forming the protective layer 13, the shape of the second surface lObs of the semiconductor substrate 10, a condition of firing for forming the second collecting electrode E21, and the like.

The second output extracting electrode E22 is positioned on the passivation layer 12 so as to extend linearly along the +Y direction as the first direction. In the first embodiment, as shown in Figs. 5 to 7, in plan view of the second element surface 1bs, the second collecting electrode E21 is positioned so as to overlap an outer circumference portion of the second output extracting electrode E22. In other words, the second collecting electrode E21 is positioned in a state of overlapping and being in contact with a part of the second output extracting electrode E22.

The second output extracting electrode E22 can collect carriers, generated by photoelectric conversion in response to light irradiation in the semiconductor substrate 10, via the second collecting electrode E21 and extract electricity to the outside of the solar cell element 1. As shown in Figs. 5 to 7, the second output extracting electrode E22 is in a state of being positioned on the passivation layer 12 so as to extend linearly along the first direction (+Y direction) while being electrically connected to one or more second through electrodes E232 while being electrically connected to the second collecting electrode E21. In the example in Figs. 5 to 7, the second output extracting electrode E22 is positioned on the protective layer 13, positioned on the passivation layer 12 while being electrically connected to the one or more second through electrodes E232. In other words, in the example in Figs. 5 to 7, the second output extracting electrode E22 is, for example, positioned on the passivation layer 12 so that a state where the second output extracting electrode E22 and the passivation layer 12 sandwich the protective layer 13 is achieved.

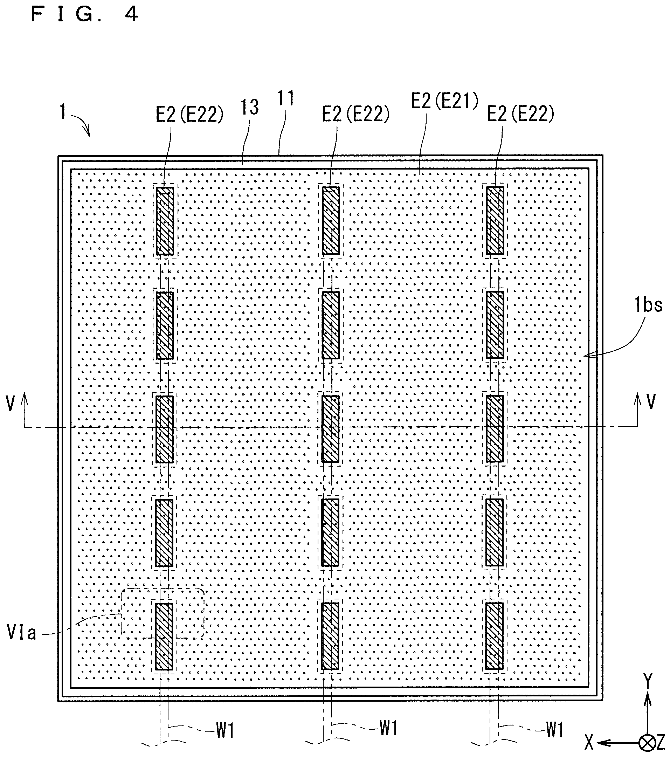

In the example in Fig. 4, three second output extracting electrodes E22 are provided on the second surface lObs side of the semiconductor substrate 10. Each of the second output extracting electrodes E22 has a longitudinal direction along the second surface lObs. This longitudinal direction is the +Y direction. Each of the second output extracting electrodes E22 includes N (N is an integer that is equal to or larger than 2) island-shaped electrode portions (also referred to as island-shaped electrode portions) arranged along the +Y direction as the longitudinal direction. Here, N is five. That is, on the second surface lObs side of the semiconductor substrate 10, there are three rows of island-shaped electrode portions arranged along the longitudinal direction (here, the +Y direction) of the respective second output extracting electrodes E22. The second output extracting electrodes E22 have a width direction intersecting the longitudinal direction. This width direction is the +X direction.

The thickness of the second output extracting electrodes E22 is, for example, about 5 µm to 20 µm. The width of the second output extracting electrodes E22 is, for example, about 0.8 mm to 3 mm. The second output extracting electrodes E22 can be formed by applying and firing conductive paste, for example. The application of the conductive paste can be realized by, for example, screen-printing or the like. For example, when the conductive paste is applied on the protective layer 13, the conductive paste may also be applied in the second B holes H32 or in the second B holes H32 and the first B holes H12. Thus, the second output extracting electrode E22 and the second through electrodes E232 can be formed simultaneously by firing the conductive paste.

Here, for example, when the second output extracting electrodes E22 contain silver as a main component, conductive paste containing silver as a main component (also referred to as silver paste) is adopted for the conductive paste for forming the second output extracting electrodes E22. The silver paste contains, for example, metal powder containing silver as a main component, an organic vehicle, and glass frits. This silver paste may be produced, for example, by kneading the metal powder containing silver, the glass frits, and the organic vehicle. In this case, about 70% to 80% by mass of the total mass of the silver paste is the metal powder containing silver, about 5% to 20% by mass of the total mass is the organic vehicle, and about 2% to 15% by mass is the glass frits, for example.

Here, the silver paste containing silver as a main component may include, for example, silver and copper as main components. The particle size of the metal powder containing silver is, for example, about 0.05 µm to 20 µm. The particle size of the metal powder containing silver may be, for example, about 0.1 µm to 5 µm. The organic vehicle is prepared, for example, by adding a resin component serving as a binder to an organic solvent. As the binder, for example, a cellulose resin such as ethyl cellulose, an acrylic resin, an alkyd resin, or the like is used. As the organic solvent, for example, diethylene glycol monobutyl ether acetate, terpineol, diethylene glycol monobutyl ether, or the like is used. As the glass frits, for example, lead glass such as Al₂O₃-SiO₂-PbO is adopted. Furthermore, as the glass frits, for example, lead-free glass such as B₂O₃-SiO₂-Bi₂O₃ or B₂O₃-SiO₂-ZnO may be adopted.

For example, in a case that the protective layer 13 is formed by the wet process, the silver paste directly applied on the passivation layer 12 in the second B holes H32 of the protective layer 13, causes firing through in the passivation layer 12 when the silver paste is fired. In this process, the first B holes H12 of the passivation layer 12 may be formed. Furthermore, for example, the second through electrode E232 in a state of being connected to the second output extracting electrode E22 and directly connected to the second surface lObs of the semiconductor substrate 10 may be formed. For example, in a case that the protective layer 13 is formed by the dry process, a state where the second B holes H32 and the first B holes H12 are formed by laser irradiation or the like is achieved. Therefore, the silver paste is directly applied onto the second surface lObs of the semiconductor substrate 10 in the second connected hole, including the second B hole portion H32 and the first B hole portion H12 that are in the state of being continuously connected to each other. Thus, when the silver paste is fired, the second through electrode E232 may be formed even without causing the firing through of the silver paste in the passivation layer 12. Thus, the second output extracting electrode E22 may be formed with the firing through of the silver paste in the passivation layer 12, or without the firing through of the silver paste in the passivation layer 12. Here, whether the firing through in the passivation layer 12 occurs or the level of the firing through can be controlled as appropriate, by setting as appropriate the component of the glass flits included in the silver paste used for forming the second output extracting electrode E22.

Here, for example, the firing through of the silver paste in the passivation layer 12 can occur when bismuth oxide is contained in the glass frits. In this case, for example, occurrence of the firing through of the silver paste in the passivation layer 12 can be facilitated by increasing the amount of bismuth oxide contained in the glass frits. On the other hand, for example, occurrence of the firing through of the silver paste in the passivation layer 12 can be suppressed when zinc oxide is contained in the glass frits. In this case, for example, occurrence of the firing through of the silver paste in the passivation layer 12, can be more effectively suppressed by increasing the amount of zinc oxide contained in the glass frits.

Here, for example, when the thickness of the protective layer 13 is sufficiently larger than the thickness of the passivation layer 12, no firing through of the silver paste in the passivation layer 12 occurs in a portion of the passivation layer 12 covered with the protective layer 13. Thus, the passivation layer 12 with a pattern corresponding to the desired pattern of the protective layer 13 can be provided on the second surface lObs of the semiconductor substrate 10 in the solar cell element 1. The thickness of the protective layer 13 is set as appropriate, for example, in accordance with the composition of the insulating paste for forming the protective layer 13, the shape of the second surface lObs of the semiconductor substrate 10, a condition of firing for forming the second output extracting electrode E22, and the like.

When the solar cell strings SG1 are manufactured by electrically connecting a plurality of solar cell elements 1 in series, as shown in Fig. 3 and Fig. 4, between the adjacent solar cell elements 1, the second output extracting electrode E22 and the first output extracting electrode E11 are connected to each other by the first wiring member W1. In this case, the first wiring member W1 is joined to the second output extracting electrode E22 and the first output extracting electrode E11 by soldering or the like, for example.

### <1-3. Configuration on Second Element Surface Side of Solar Cell Element>

As shown in Figs. 5 to 7, for example, the second output extracting electrode E22 is positioned while being connected to the second surface lObs of the semiconductor substrate 10 via the second through electrode E232. Here, for example, the second through electrode E232, connected to the second output extracting electrode E22, is in the first B holes H12 and the second B holes H32, so that the second output extracting electrode E22 is firmly joined to the second surface lObs side of the semiconductor substrate 10 due to anchor effect. Furthermore, for example, when the second through electrode E232 is formed, the glass component included in the silver paste melts and enters the surface layer part on the second surface lObs side of the semiconductor substrate 10. Thus, the second output extracting electrode E22 may be more firmly joined to the semiconductor substrate 10 via the second through electrode E232. With the joining strength of the second output extracting electrode E22 to the semiconductor substrate 10 thus increased, for example, the second output extracting electrode E22 is less likely to be peeled off from the semiconductor substrate 10. As a result, long-term reliability of the solar cell element 1 can be improved.

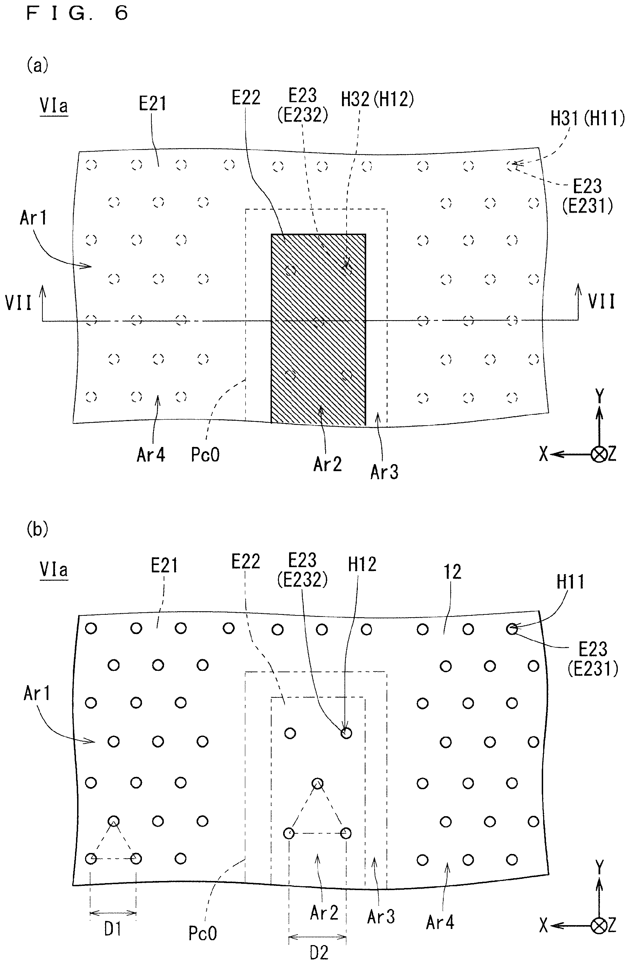

As shown in figs. 6(a) and 6(b), for example, a case where the second output extracting electrode E22 and the second collecting electrode E21 are seen in plane perspective view, by seeing through the second element surface 1bs, is assumed. In this case, a region where the second collecting electrode E21 is positioned is referred to as a first region Ar1, and a region where the second output extracting electrode E22 is positioned is referred to as a second region Ar2. For example, a ratio of an area occupied by two or more first through electrodes E231 (also referred to as a first area) in the first region Ar1 is defined as a first area ratio, and a ratio of an area occupied by one or more second through electrodes E232 (also referred to as a second area) in the second region Ar2 is defined as a second area ratio. In this case, for example, the second area ratio is smaller than the first area ratio.

Here, when the second element surface 1bs is seen in plane perspective view, the first area occupied by the two or more first through electrodes E231 in the first region Ar1 and the second area occupied by the one or more second through electrodes E232 in the second region Ar2 can be obtained as follows for example. First of all, for example, in the solar cell element 1, the second collecting electrode E21 mainly containing aluminum and the second output extracting electrode E22 mainly containing silver are dissolved using hydrochloric acid. Then, for example, the first area and the second area described above can be calculated by observing the number, the size, and the like of laser traces remaining on the second surface lObs of the semiconductor substrate 10 using an optical microscope or a scanning electron microscope (SEM). Here, for example, the first area and the second area described above may be calculated by observing the number, the size, and the like of the second holes H3 remaining in the protective layer 13 using an optical microscope or a SEM.

In the example in Fig. 5 to Fig. 6(b), when the second element surface 1bs is seen in plane perspective view, a plurality of the first through electrodes E231 are positioned to be arranged so that three virtual lines virtually connecting the center points of three adjacent first through electrodes E231 form an equilateral triangle in the first region Ar1. Here, a distance (also referred to as a first pitch) D1 between the center points of two adjacent first through electrodes E231 is set to, for example, about 0.5 mm to 0.8 mm. In the example in Fig. 5 to Fig. 6(b), when the second element surface 1bs is seen in plane perspective view, a plurality of the second through electrodes E232 are positioned to be arranged so that three virtual lines virtually connecting the center points of three adjacent second through electrodes E232 form an equilateral triangle in the second region Ar2. Here, a distance (also referred to as a second pitch) D2 between the center points of two adjacent second through electrodes E232 is set to, for example, about 1 mm to 8 mm. The shape of the plurality of first through electrodes E231 and second through electrodes E232 seen in plane perspective view may be, for example, a dot shape as shown. Furthermore, the shape of the plurality of first through electrodes E231 and second through electrodes E232 seen in plane perspective view may be, for example, a linear shape (or strip shape).

Thus, for example, the decreased amount of the passivation layer 12 may be decreased when the density of the second through electrode E232 immediately below the second output extracting electrode E22 is set to be smaller than the density of the first through electrode E231 immediately below the second collecting electrode E21. Thus, the recombination of minority carriers is less likely to occur in the vicinity of the second surface lObs of the semiconductor substrate 10 for example. As a result, the photoelectric conversion efficiency of the solar cell element 1 can be improved. Therefore, the photoelectric conversion efficiency and long-term reliability of the PERC type solar cell element 1 can be improved in a well-balanced manner.

A region where the first region Ar1 and the second region Ar2 are in a state of overlapping each other when the second element surface 1bs is seen in plane perspective view is referred to as an overlapping region Ar3. The overlapping region Ar3 is a region where the second collecting electrode E21 and the second output extracting electrode E22 overlap. A region where the first region Ar1 and the second region Ar2 are in a state of being in contact with each other is referred to as a connection region Pc0. The connection region Pc0 is a region where the second collecting electrode E21 and the second output extracting electrode E22 are in a state of being in contact with each other. Here, for example, as shown in Figs. 5 to 7, the second collecting electrode E21 may contain aluminum, the second output extracting electrode E22 may contain silver, and the plurality of through electrodes E23 may be positioned in a state of avoiding the overlapping region Ar3 and the connection region Pc0. In other words, when the second element surface 1bs is seen in plane perspective view, the plurality of through electrodes E23 may be positioned in a region (also referred to as a non-connection region) Ar4, in the first region Ar1 and the second region Ar2, different from both the overlapping region Ar3 and the connection region Pc0. Furthermore, in other words, when the second element surface 1bs is seen in plane perspective view, the plurality of through electrodes E23 is positioned in neither the overlapping region Ar3 nor the connection region Pc0, in the first region Ar1 and the second region Ar2.

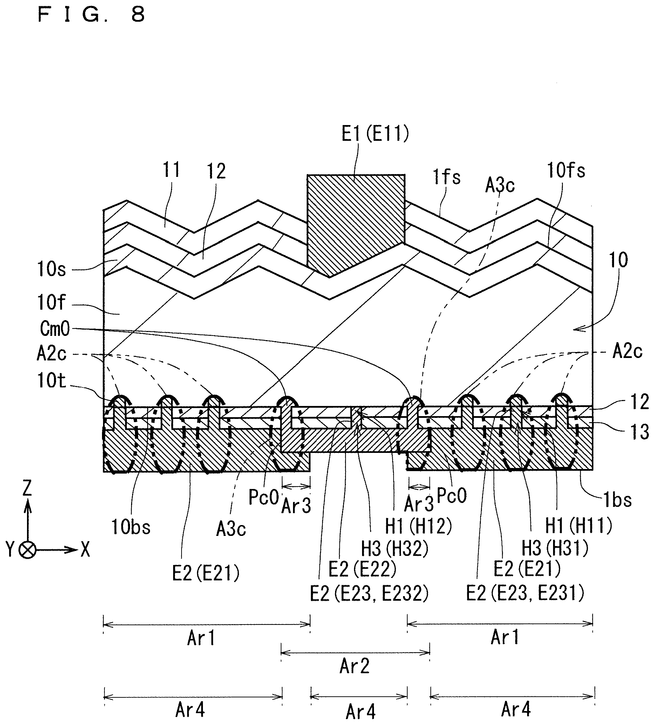

Here, for example, as shown in Fig. 8, it is assumed that the through electrode E23 is positioned in the overlapping region Ar3 and the connection region Pc0. In this case, a ternary (or a Si-Al-Ag ternary) alloy portion Cm0 including silicon, aluminum, and silver may be formed in a region A3c including the through electrode E23 positioned in the overlapping region Ar3 and the connection region Pc0. This Si-Al-Ag ternary alloy portion Cm0 is, for example, formed by interdiffusion of silicon, aluminum and silver among the semiconductor substrate 10, the aluminum paste, and the silver paste, when firing the aluminum paste and the silver paste. For example, as shown in Fig. 8, a binary (or a Si-Al binary) alloy portion including silicon and aluminum may be formed in a region A2c, in the non-connection region Ar4, including the first through electrode E231 positioned in the first region Ar1. This Si-Al binary alloy portion is, for example, formed by interdiffusion of silicon and aluminum between the semiconductor substrate 10 and the aluminum paste, when firing the aluminum paste. In Fig. 8, the region A2c and the region A3c are each a region surrounded by a thick two-dot chain line.

On the other hand, in the first embodiment, for example, when the second element surface 1bs is seen in plane perspective view, the plurality of through electrodes E23 are positioned in the non-connection region Ar4 different from the overlapping region Ar3 or the connection region Pc0. Thus, for example, when the second collecting electrode E21 and the second output extracting electrode E22 are formed on the second surface lObs side of the semiconductor substrate 10 in the overlapping region Ar3 and the connection region Pc0 in plane perspective view, the formation of the Si-Al-Ag ternary alloy portion Cm0 is suppressed. Thus, for example, the solar cell element 1 is less likely to have cracks and breaking from the alloy portion Cm0, upon bending due to the application of a load. As a result, the photoelectric conversion efficiency and long-term reliability of the PERC type solar cell element 1 can be improved, for example.

When the conductive paste is fired for forming the second collecting electrode E21 and the second output extracting electrode E22, gas is produced due to thermal decomposition of a binder included in each of the conductive pastes for forming the second collecting electrode E21 and the second output extracting electrode E22. Here, when the semiconductor substrate 10 is seen in plane perspective view, the amount of gas produced per unit area due to the thermal decomposition of the binder is proportional to the thicknesses of the second collecting electrode E21 and the second output extracting electrode E22. Here, for example, a case is assumed where the second output extracting electrode E22 has a smaller thickness than that of the second collecting electrode E21. In this case, in the overlapping region Ar3, the conductive paste for forming the second output extracting electrode E22 involves a smaller amount of gas produced due to the thermal decomposition of the binder, than the conductive paste for forming the second collecting electrode E21 does.

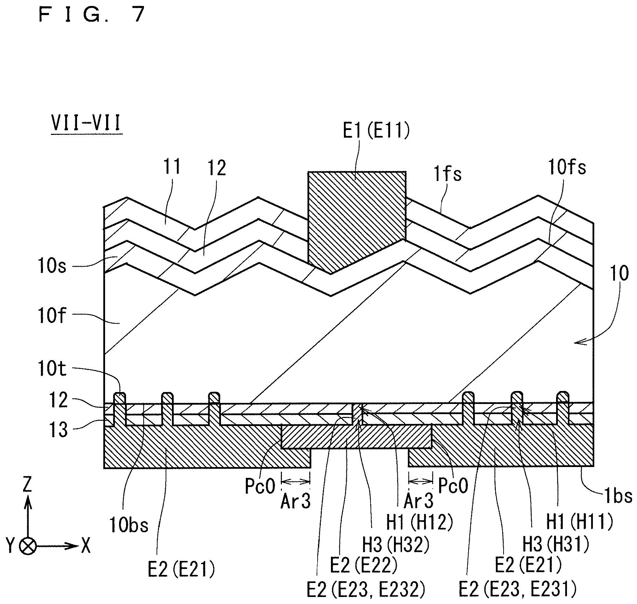

Therefore, for example, in the overlapping region Ar3, it is conceivable to position the second output extracting electrode E22, which is thinner than the second collecting electrode E21, on the second surface lObs, and to position the second collecting electrode E21 on the second output extracting electrode E22, as shown in Fig. 7. Such a configuration involves a smaller amount of gas generated due to the thermal decomposition of the binder during the firing of the conductive paste for forming the second output extracting electrode E22, which is one of the second collecting electrode E21 and the second output extracting electrode E22 positioned closer to the semiconductor substrate 10. Thus, for example, the adhesion strength between the second collecting electrode E21 and the second output extracting electrode E22 is less likely to be disadvantageously compromised due to gas entering the interface between the second collecting electrode E21 and the second output extracting electrode E22. As a result, the photoelectric conversion efficiency and long-term reliability of the PERC type solar cell element 1 can be improved, for example.

### <1-4. Method for Manufacturing Solar Cell Element>

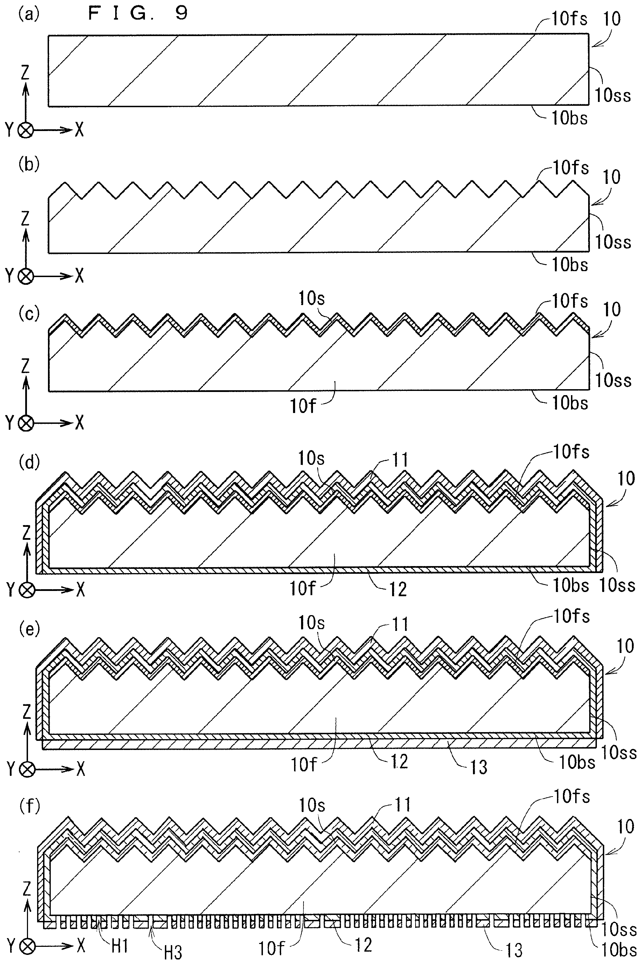

Next, an example of a method for manufacturing the solar cell element 1 will be described with reference to Fig. 9(a) to Fig. 9(f) and Fig. 5.

First of all, as shown in Fig. 9(a), the semiconductor substrate 10 is prepared. Here, as the semiconductor substrate 10, a monocrystalline silicon or polycrystalline silicon substrate is employed. The semiconductor substrate 10 is formed by, for example, the Czochralski (CZ) method, casting, or other existing method. Here, when a p-type polycrystalline silicon substrate is prepared as the semiconductor substrate 10, for example, a polycrystalline silicon ingot is produced by casting. Here, the resistivity of the ingot is adjusted to be about 1 Ω·cm to about 5 Ω·cm by adding, for example, boron as a dopant element. Next, the ingot is cut into, for example, a rectangular parallelepiped shape having a square bottom surface with a side of about 160 mm, and further sliced to have a thickness of about 200 µm, whereby the semiconductor substrate 10 is produced. Here, for example, a very small amount of etching is performed on the surface of the semiconductor substrate 10 using an aqueous solution such as sodium hydroxide, potassium hydroxide, hydrofluoric acid, or nitric hydrofluoric acid. Thus, a mechanically damaged layer on a cutting surface and a contaminated layer of the semiconductor substrate 10 can be removed.

Next, as shown in Fig. 9(b), a texture is formed on the first surface 10fs of the semiconductor substrate 10. The texture can be formed by, for example, wet etching using an alkaline aqueous solution such as sodium hydroxide or an acidic aqueous solution such as nitric hydrofluoric acid, or dry etching using reactive ion etching (RIE) or the like.

Next, as shown in Fig. 9(c), the second semiconductor region 10s, which is an n-type semiconductor region, is formed at the first surface 10fs of the semiconductor substrate 10 having the texture. Specifically, the n-type second semiconductor region 10s is formed in the surface layer part on the first surface 10fs side of the semiconductor substrate 10 having the texture. The second semiconductor region 10s may be formed, for example, by a coating thermal diffusion method in which diphosphorus pentoxide (P₂O₅) in a paste state is applied to the surface of the semiconductor substrate 10 and phosphorus is thermally diffused, a vapor phase thermal diffusion method in which phosphorus oxychloride (POCl₃) in a gaseous state is used as a diffusion source, or the like. The second semiconductor region 10s is formed to have, for example, a depth of about 0.1 µm to 2 µm and a sheet resistance value of about 40 Ω/□ to 200 Ω/□. For example, in the vapor phase thermal diffusion method, the semiconductor substrate 10 is subjected to heat treatment in an atmosphere containing gas as a diffusion source such as POCl₃ at a temperature of about 600°C to 800°C for about 5 minutes to 30 minutes, so that phosphorus silicon glass (PSG) is formed on the surface of the semiconductor substrate 10. The semiconductor substrate 10 is then thermally treated in an atmosphere of an inert gas, such as argon or nitrogen, at a high temperature of about 800°C to 900°C for about 10 minutes to 40 minutes. Thus, phosphorus is diffused from the PSG into the surface layer part of the semiconductor substrate 10, and the second semiconductor region 10s is formed on the first surface 10fs side of the semiconductor substrate 10.

Here, for example, when the second semiconductor region is also formed on the second surface lObs side in the process of forming the second semiconductor region 10s, the second semiconductor region formed on the second surface lObs side is removed by etching. For example, the second semiconductor region formed on the second surface lObs side can be removed by immersing the second surface lObs side of the semiconductor substrate 10 into an aqueous solution of nitric hydrofluoric acid. Thus, the first semiconductor region 10f with a p-type conductivity can be exposed on the second surface lObs of the semiconductor substrate 10. Then, the PSG, which has adhered to the first surface 10fs side of the semiconductor substrate 10 at the time of forming the second semiconductor region 10s, is removed by etching. In this process, the second semiconductor region formed on the side surface lOss of the semiconductor substrate 10 may also be removed. For example, a diffusion mask may be formed in advance on the second surface lObs side of the semiconductor substrate 10, and the second semiconductor region 10s may be formed by the vapor phase thermal diffusion method or the like, and subsequently, the diffusion mask may be removed. In this case, the step of removing the second semiconductor region on the second surface lObs side is unnecessary because the second semiconductor region is not formed on the second surface lObs side.

With the above processing, the semiconductor substrate 10 including the first semiconductor region 10f, and including the second semiconductor region 10s, which is an n-type semiconductor region, positioned on the first surface 10fs side, and having the texture formed on the first surface 10fs can be prepared.

Next, as shown in Fig. 9(d), the passivation layer 12 mainly containing, for example, aluminum oxide is formed on at least the second surface lObs of the semiconductor substrate 10. The passivation layer 12 can be formed by, for example, ALD, PECVD, or the like. Here, for example, if ALD is used, the surface of the semiconductor substrate 10 can be covered with the passivation layer 12 in a more gapless and dense manner. For example, in the step of forming the passivation layer 12 by ALD, first of all, the semiconductor substrate 10 in which the second semiconductor region 10s has been formed is placed in a chamber of a film forming apparatus. Then, in a state where the semiconductor substrate 10 is heated in a temperature range of 100°C to 250°C, four steps of supply of the aluminum raw material, removal of the aluminum raw material by exhaust, supply of an oxidizing agent, and removal of the oxidizing agent by exhaust are repeated multiple times. The passivation layer 12 mainly including aluminum oxide is thereby formed on the semiconductor substrate 10. As the aluminum raw material, for example, trimethylaluminum (TMA), triethylaluminum (TEA), or the like can be used. For example, water, ozone gas, or the like is used as the oxidizing agent. If ALD is used, a passivation layer may be formed to not only on the second surface lObs of the semiconductor substrate 10 but also over the entire circumference of the semiconductor substrate 10 including the side surface lOss of the semiconductor substrate 10. Here, for example, after applying an acid-resistant resist to the passivation layer 12 on the second surface lObs of the semiconductor substrate 10, an unnecessary passivation layer may be removed by etching using hydrofluoric acid or the like.

Next, as shown in Fig. 9(d), the antireflection film 11 containing, for example, silicon nitride or the like is formed on at least the first surface 10fs of the semiconductor substrate 10. The antireflection film 11 is formed by, for example, PECVD or sputtering. When PECVD is applied, the semiconductor substrate 10 is heated in advance at a temperature higher than a temperature at which the antireflection film 11 is formed. Then, a mixed gas of silane (SiH₄) and ammonia (NH₃) is diluted with nitrogen (N₂), is made into plasma by glow discharge decomposition at a reaction pressure of about 50 Pa to 200 Pa, and is deposited on the heated semiconductor substrate 10. As a result, the antireflection film 11 is formed on the semiconductor substrate 10. Here, the film forming temperature is about 350°C to 650°C. A frequency of a high-frequency power supply required for glow discharge is set to be about 10 kHz to 500 kHz. The flow rate of the gas is determined as appropriate in accordance with the size of the reaction chamber and the like. The flow rate of the gas is, for example, in the range of about 150 ml/min (sccm) to 6000 ml/min (sccm). Here, a value (B/A) obtained by dividing a flow rate B of ammonia gas by a flow rate A of silane gas is in a range of 0.5 to 15.

Next, as shown in Fig. 9(e), the protective layer 13 containing silicon nitride or the like is formed on the passivation layer 12 formed on the second surface lObs of the semiconductor substrate 10. If the protective layer 13 is silicon nitride, the protective layer 13 can be formed by a method that is the same as that used for the antireflection film 11 using PECVD described above.

Next, as shown in Fig. 9(f), connected holes are formed through the protective layer 13 and the passivation layer 12. Here, for example, by irradiating the protective layer 13 and the passivation layer 12 with laser beams from above to reach the surface of the semiconductor substrate 10, a plurality of connected holes are formed through the protective layer 13 and the passivation layer 12. For example, by adjusting an output of the laser beams and the like, the plurality of connected holes (about 400 to 700 connected holes per 1 cm²) each having a diameter of about 30 µm to 150 µm and having a cylindrical shape are formed to be evenly distributed, in plan view of the second surface lObs side of the semiconductor substrate 10. Note that, in a portion where the second output extracting electrode E22 is formed, the plurality of connected holes (about 10 to 200 connected holes per 1 cm²) are formed to be evenly distributed. For example, when the semiconductor substrate 10 is seen from the second surface lObs side in plane perspective view, a plurality of connected holes are formed so as to avoid the overlapping region Ar3, the connection region Pc0, and the periphery of these regions. For example, a neodymium doped, yttrium/aluminum/garnet (Nd:YAG) laser with a Q switch, emitting laser beam with a wavelength of 1064 nm, is adopted for the laser apparatus used in this process. As the laser beam, for example, a second harmonic (second harmonic generation (SHG), wavelength 532 nm) of the Nd:YAG laser or the like may be used. For example, when the second harmonic of the Nd:YAG laser with a Q switch is used, conditions are employed including: an oscillation frequency of about 10 kHz, an output of about 7 W to 10 W, and a laser beam diameter of about 100 µm.

Next, as shown in Fig. 5, the front electrode E1 and the back electrode E2 are formed. Here, for example, silver paste as conductive paste for forming the front electrode E1 is applied on the first surface 10fs side of the semiconductor substrate 10 in a desired pattern. Furthermore, for example, on the second surface lObs side of the semiconductor substrate 10, silver paste as conductive paste for forming the second output extracting electrode E22 and the second through electrode E232 of the back electrode E2 is applied in a desired pattern. The silver paste can be applied by, for example, screen printing or the like. The silver paste that has been applied is dried at a predetermined temperature. At this time, the solvent of the silver paste evaporates, so that the silver paste is dried. Furthermore, for example, on the second surface lObs side of the semiconductor substrate 10, aluminum paste as conductive paste for forming the second collecting electrode E21 and the first through electrode E231 of the back electrode E2 is applied in a desired pattern. The aluminum paste can be applied by, for example, screen printing or the like. The aluminum paste that has been applied is dried at a predetermined temperature. At this time, the solvent of the aluminum paste evaporates, so that the aluminum paste is dried.

Then, the semiconductor substrate 10 on which the silver paste and the aluminum paste are applied is subjected to heat treatment. Specifically, the semiconductor substrate 10 is kept at a temperature around the maximum temperature of about 700°C to 900°C for 0.1 to several tens of seconds in a firing furnace. Thus, the silver paste and the aluminum paste are fired. Thus, the metal powder in each of the silver paste and the aluminum paste is sintered, whereby the front electrode E1 and the back electrode E2 are formed. Specifically, for example, the silver paste applied on the first surface 10fs side of the semiconductor substrate 10 causes firing through in the antireflection film 11 and the like. Thus, the connection to the n-type second semiconductor region 10s on the first surface 10fs of the semiconductor substrate 10 is achieved, whereby the front electrode E1 is formed. Furthermore, at this time, the second output extracting electrode E22 and the second through electrode E232 are formed due to the firing of the silver paste applied to the second surface lObs of the semiconductor substrate 10. Furthermore, at this time, the second collecting electrode E21 and the first through electrode E231 are formed due to the firing of the aluminum paste applied to the second surface lObs of the semiconductor substrate 10. Here, when the first through electrode E231 is formed, aluminum in the aluminum paste diffuses into the surface layer part of the second surface lObs of the semiconductor substrate 10, whereby the third semiconductor region 10t as a BSF layer is formed.

Through the above steps, the solar cell element 1 as shown in Fig. 5 is formed.

### <1-5. Method for Manufacturing Solar Cell Module>

For example, the first member 101, the first filler 102u, the solar cell unit 103 including the plurality of solar cell strings SG1, the second filler 102b, and the second member 104 are stacked in this order. Then, for example, the first member 101, the first filler 102u, the solar cell unit 103, the second filler 102b, and the second member 104 are integrated by a laminator. Thus, the solar cell module 100 as shown in Fig. 2(a) or Fig. 2(b) can be manufactured. The solar cell module 100 might be deflected upon receiving an external force due to, for example, pressure of snow, wind, or the like. Still, in the solar cell element 1 used in the solar cell module 100, the second output extracting electrode E22 is less likely to be peeled off from the semiconductor substrate 10. As a result, long-term reliability of the solar cell module 100 can be improved.

Here, on a second module surface Ms2 of the solar cell module 100, for example, a terminal box Bx1 is attached for extracting electricity obtained by photoelectric conversion in the solar cell unit 103. Furthermore, for example, a frame member may be attached to an outer circumference portion of the solar cell module 100. Thus, the solar cell module 100 can be reinforced.

### <1-6. Specific Examples>

Hereinafter, a production method and a breaking load of solar cell elements according to Reference Example 1, Reference Example 2, and Reference Example 3 as well as the solar cell element 1 according to Example will be described.

### <1-6-1. Production of Solar Cell Element According to Reference Example 1>

First of all, as shown in Fig. 9(a), a semiconductor substrate 10 was prepared. Here, 20 polycrystalline silicon substrates were produced as the semiconductor substrates 10 by casting. At this time, the polycrystalline silicon substrates were doped with boron to have the p-type conductivity. The polycrystalline silicon substrates had a specific resistance value of about 1.0 Ω·cm, a square planar shape with a side of about 156 mm, and a thickness of about 180 µm.

Next, a portion to a depth of about 5 µm to 10 µm from the front surface of the semiconductor substrate 10 was removed by etching using an aqueous sodium hydroxide solution. Next, as shown in Fig. 9(b), the texture was formed on the first surface 10fs side of the semiconductor substrate 10 by RIE.

Next, as shown in Fig. 9(c), by a vapor phase thermal diffusion method in which phosphorus oxychloride (POCl₃) was used as a diffusion source, the second semiconductor region with the n-type conductivity was formed in the surface layer part over the entire circumference of the surface of the semiconductor substrate 10. Then, the second semiconductor region formed on the second surface lObs side and on the side surface lOss side of the semiconductor substrate 10 was removed by immersing portions of the semiconductor substrate 10 on the second surface lObs side and on the side surface lOss side in a mixed solution of hydrofluoric acid and nitric acid. As a result, the second semiconductor region 10s with the n-type conductivity was formed in the surface layer part on the first surface 10fs side of the semiconductor substrate 10. The second semiconductor region 10s had a sheet resistance of about 100 Ω/□.

Next, as shown in Fig. 9(d), the passivation layer 12 mainly containing aluminum oxide was formed on the surface over the entire circumference of the semiconductor substrate 10 by ALD. The thickness of the passivation layer 12 formed was about 10 nm.

Furthermore, as shown in Fig. 9(d), the silicon nitride antireflection film 11 was formed on the first surface 10fs side of the semiconductor substrate 10 by PECVD. The antireflection film 11 thus formed had a refractive index of about 2.1 and a thickness of about 70 nm.

Next, as shown in Fig. 9(e), the protective layer 13 containing silicon nitride was formed on the passivation layer 12, formed on the second surface lObs of the semiconductor substrate 10, by PECVD. This protective layer 13 had a refractive index of about 2.1 and a thickness of about 90 nm.

Next, as shown in Fig. 9(f), a plurality of connected holes were formed through the protective layer 13 and the passivation layer 12 by using a laser apparatus. Here, a Nd:YAG laser with a Q switch was used as the laser apparatus. In this laser apparatus, the second harmonic of the Nd:YAG laser was used. Here, the plurality of connected holes were formed to be evenly distributed over the entire surface on the second surface lObs side of the semiconductor substrate 10, with the connected holes having a diameter of about 100 µm and the first pitch D1 shown in Fig. 6(b) described above set to be about 0.65 mm.

Next, silver paste for forming the front electrode E1 including the first output extracting electrode E11, the first collecting electrode E12, and the auxiliary electrode E13 was applied on the first surface 10fs side of the semiconductor substrate 10. As the silver paste, paste containing about 85% by mass of silver as a main component and further containing glass frits and an organic vehicle was used. Such silver paste was applied on the first surface 10fs side of the semiconductor substrate 10 by screen printing to be in the pattern shown in Fig. 3. Here, the thickness of the silver paste immediately after the printing was about 18 µm. Then, the silver paste that has been applied was dried at a temperature of about 150°C for about 3 minutes. Thus, the solvent of the silver paste evaporated.

Next, silver paste for forming the second output extracting electrode E22 of the back electrode E2 was applied on the second surface lObs side of the semiconductor substrate 10 by screen printing to be in the pattern of the second output extracting electrode E22 shown in Fig. 4. As the silver paste, paste containing about 65% by mass of silver as a main component and further containing glass frits and an organic vehicle was used. Here, the thickness of the silver paste immediately after the printing was about 15 µm. Then, the silver paste that has been applied was dried at a temperature of about 150°C for about 3 minutes. Thus, the solvent of the silver paste evaporated.

Next, aluminum paste for forming the second collecting electrode E21 of the back electrode E2 was applied on the second surface lObs side of the semiconductor substrate 10. As the aluminum paste, paste containing about 75% by mass of aluminum as a main component and further containing glass frits and an organic vehicle was used. Such aluminum paste was applied on the second surface lObs side of the semiconductor substrate 10 by screen printing to be in the pattern of the second collecting electrode E21 shown in Fig. 4. Here, the thickness of the aluminum paste immediately after the printing was about 48 µm. Then, the aluminum paste that has been applied was dried at a temperature of about 150°C for about 3 minutes. Thus, the solvent of the aluminum paste evaporated.

Next, the semiconductor substrate 10 with the silver paste applied on the first surface 10fs side and the silver paste and the aluminum paste applied on the second surface lObs side was maintained at a peak temperature of about 700°C for about 10 seconds. Thus, the silver paste and the aluminum paste were fired. Thus, the front electrode E1 and the back electrode E2 were formed. Here, the back electrode E2 included a plurality of through electrodes E23. As a result, the solar cell element according to Reference Example 1 was produced.

### <1-6-2. Production of Solar Cell Element According to Reference Example 2>

The solar cell element according to Reference Example 2 was produced through production steps as a result of omitting the step of forming the plurality of connected holes by using the laser apparatus as shown in Fig. 9(f) from the production steps for the solar cell element according to Reference Example 1. Therefore, the solar cell element according to Reference Example 2 was obtained with all the connected holes and the through electrodes E23 omitted from the solar cell element according to Reference Example 1.

### <1-6-3. Production of Solar Cell Element According to Reference Example 3>

In the step of forming the plurality of connected holes by using the laser apparatus as shown in Fig. 9(f), which is one of the steps for producing the solar cell element according to Reference Example 1, the plurality of connected holes were formed to avoid the second region Ar2 when the semiconductor substrate 10 is seen from the second surface lObs side in plane perspective view. Here, the second region Ar2 was a region where the second output extracting electrode E22 was to be formed. Such a plurality of connected holes were formed by modifying the program for controlling laser beam scanning by the laser apparatus. Thus, the solar cell element according to Reference Example 3 was produced with all the connected holes and the through electrodes E23 in the second region Ar2 immediately below the second output extracting electrode E22 omitted from the solar cell element according to Reference Example 1.

### <1-6-4. Production of Solar Cell Element According to Example>

In the step of forming the plurality of connected holes by using the laser apparatus as shown in Fig. 9(f), which is one of the steps for producing the solar cell element according to Reference Example 1, the plurality of connected holes were formed to avoid the overlapping region Ar3 when the semiconductor substrate 10 is seen from the second surface lObs side in plane perspective view. As described above, the overlapping region Ar3 was a region in a state in which the second region Ar2 in which the second output extracting electrode E22 was to be formed and the first region Ar1 in which the second collecting electrode E21 was to be formed overlapped. Furthermore, in the second region Ar2, the second connected hole to be the second through electrode E232 was formed with the second pitch D2 shown in Fig. 6(b) set to be about 1.3 mm. Such a plurality of second connected holes were formed by modifying the program for controlling laser beam scanning by the laser apparatus. Thus, the solar cell element according to Example was produced with all the connected holes and the through electrodes E23 in the overlapping region Ar3 omitted from the solar cell element according to Reference Example 1.

### <1-6-5. Measuring Method of Breaking Load>

In the manner described above, 20 sheets of each of solar cell elements according to Reference Example 1, Reference Example 2, Reference Example 3, and Example were produced. Then, for each of the solar cell elements according to Reference Example 1, Reference Example 2, Reference Example 3, and Example, the breaking load was measured for 20 sheets.

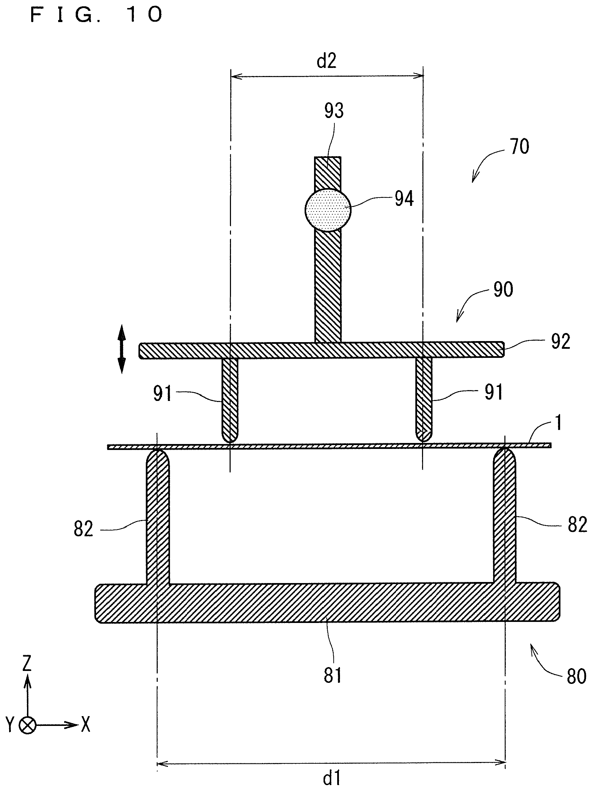

As shown in Fig. 10, an apparatus including a support portion 80 and a pressing portion 90 was used as an apparatus (also referred to as a breaking load measuring apparatus) 70 for measuring the breaking load of the solar cell elements.

The support portion 80 had a base plate portion 81 and two support plate portions 82. The base plate portion 81 was a flat plate portion that was positioned in a state of extending along the horizontal direction. The two support plate portions 82 were fixed on the surface facing in the upper direction (here, the +Z direction) of the base plate portion 81. Each of the support plate portions 82 was a flat plate portion positioned in a state of extending along a vertical direction. Two support plate portions 82 were positioned in a state of facing each other. Each of the support plate portions 82 had a height of about 60 mm, a depth of about 160 mm, a thickness of about 7 mm, and an upper end portion having a semicircular cross section perpendicular to the depth direction. A distance d1 between the two support plate portions 82 was about 130 mm. The support portion 80 was made of aluminum.

The pressing portion 90 had two pressing plate portions 91, a connecting plate portion 92, an actuating plate portion 93, and a pressure sensor 94. The connecting plate portion 92 was a flat plate portion positioned in a state of extending along a horizontal direction. The two pressing plate portions 91 were fixed on the surface facing in the lower direction (here, the -Z direction) of the connecting plate portion 92. Each of the pressing plate portions 91 was a flat plate portion positioned in a state of extending along the vertical direction. The two pressing plate portions 91 were positioned in a state of being parallel to the two support plate portions 82 and facing each other. Each of the pressing plate portions 91 had a height of about 30 mm, a depth of about 160 mm, a thickness of about 5 mm, and a lower end portion having a semicircular cross section perpendicular to the depth direction. A distance d2 between the two pressing plate portions 91 was about 80 mm. Here, an intermediate position between the two pressing plate portions 91 in the +X direction matched an intermediate position between the two support plate portions 82 in the +X direction. The actuating plate portion 93 was fixed on the surface of the connecting plate portion 92 facing in the upper direction (here, the +Z direction). The two pressing plate portions 91, the connecting plate portion 92, and the actuating plate portion 93 were made of aluminum. The actuating plate portion 93 was movable in the upper and the lower directions (here, the -Z direction) at a constant speed by a servo motor. Thus, the two pressing plate portions 91 were also movable in the upper and lower directions. Furthermore, the pressure sensor 94 attached to the actuating plate portion 93 was able to measure an upward load applied to the two pressing plate portions 91.

In the breaking load measuring apparatus 70 having such a configuration, first of all, the solar cell element to be measured was placed on the upper end portions of the two support plate portions 82 with the first element surface 1fs side facing upward. Here, in the solar cell element, a distance between an end portion of the solar cell element positioned on the -X direction side and a portion of the solar cell element in a state of being supported by the support plate portion 82 positioned on the -X direction side was equal to a distance between an end portion of the solar cell element positioned on the +X direction side and a portion of the solar cell element in a state of being supported by the support plate portion 82 positioned on the +X direction side. Thereafter, the two pressing plate portions 91 were lowered at a constant speed of 20 mm/min by lowering the actuating plate portion 93 in the -Z direction. Thus, the upper surface of the solar cell element facing in the +Z direction was pressed by the two pressing plate portions 91, whereby the solar cell element was bent to be in a recessed shape. In this process, the stress applied to the two pressing plate portions 91 gradually increased, so that the bending deformation of the solar cell element increased, and suddenly dropped once the breaking and crack occurred in the solar cell element. Here, a change in the stress applied to the two pressing plate portions 91 was measured by the pressure sensor 94, and the maximum value (N) of the stress applied to the two pressing plate portions 91 immediately before the stress acting on the two pressing plate portions 91 suddenly dropped was measured as the breaking load that breaks the solar cell element.

### <1-6-6. Measurement Results of Breaking Load>

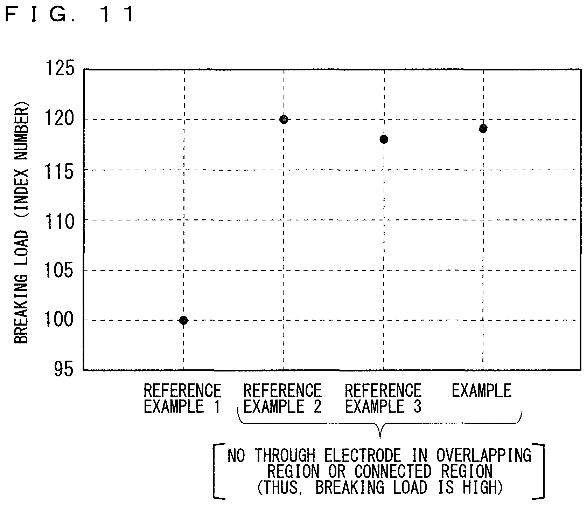

Fig. 11 shows, for each of the solar cell elements according to Reference Example 1, Reference Example 2, Reference Example 3, and Example, an average value of the breaking loads of 20 sheets. Note that, Fig. 11 shows an index of the breaking load assuming that the average value of the breaking load for the solar cell element according to Reference Example 1 is 100.

As shown in Fig. 11, compared with the solar cell element according to Reference Example 1, an increase in the breaking load of about 18% to 20% was confirmed for each of the solar cell elements according to Reference Example 2, Reference Example 3, and Example. Furthermore, there was no significant difference in the breaking load among the solar cell elements 1 according to Reference Example 2, Reference Example 3, and Example. Thus, it has been found that absence of the connected holes and the through electrodes E23 in the overlapping region Ar3 is effective for improving the breaking load due to the bending deformation in the solar cell element 1.

Here, for example, the Si-Al-Ag ternary alloy portion Cm0 was estimated to be likely to be formed in and in the vicinity of the connected holes of the overlapping region Ar3 when the back electrode E2 is formed, in the solar cell element according to Reference Example 1 including the connected holes and the through electrodes E23 in the overlapping region Ar3. On the other hand, for example, the Si-Al-Ag ternary alloy portion Cm0 was estimated to be less likely to be formed when the back electrode E2 is formed, in the solar cell elements according to Reference Example 2, Reference Example 3, and Example having no connected holes or through electrodes E23 in the overlapping region Ar3.

For example, the solar cell element according to Reference Example 2 had no connected holes or through electrodes E23 positioned in the state of being formed through the protective layer 13 and the passivation layer 12. In such a configuration, the solar cell element has no photoelectric conversion function. Thus, the solar cell element according to Reference Example 2 was actually unusable.

Here, considering the fact that mass production of solar cell elements involves slight positional shift of the overlapping region Ar3, the solar cell element according to Reference Example 3 with no connected holes or through electrodes E23 in the second region Ar2 including the overlapping region Ar3 was expected to improve the breaking load and the productivity of the solar cell element. In the solar cell element 1 according to Example including the connected holes and the through electrodes E23 in the portion of the second region Ar2 excluding the overlapping region Ar3, at least the second output extracting electrode E22 was expected to be firmly joined to the second surface lObs side of the semiconductor substrate 10 due to the anchor effect provided by the second through electrodes E232 in the connected holes.

### <1-7. Summary of First Embodiment>

In the solar cell element 1 according to the first embodiment, for example, the second output extracting electrode E22 is positioned while being connected to the second surface lObs of the semiconductor substrate 10 via the second through electrode E232. Thus, for example, the second output extracting electrode E22 can be firmly joined to the second surface lObs side of the semiconductor substrate 10 by the anchor effect provided by the second through electrode E232. Furthermore, for example, when forming the second through electrode E232, the glass component of the silver paste melts and enters the surface layer part on the second surface lObs side of the semiconductor substrate 10, whereby the second output extracting electrode E22 is more firmly joined to the semiconductor substrate 10 by the second through electrode E232. With the joining strength of the second output extracting electrode E22 to the semiconductor substrate 10 thus increased, for example, the second output extracting electrode E22 is less likely to be peeled off from the semiconductor substrate 10. As a result, long-term reliability of the solar cell element 1 can be improved.

Furthermore, for example, when the second element surface 1bs is seen in plane perspective view, the second area ratio of the second through electrode E232 in the second region Ar2 in which the second output extracting electrode E22 is positioned is lower than the first area ratio of the first through electrode E231 in the first region Ar1 in which the second collecting electrode E21 is positioned. Thus, for example, the decreased amount of the passivation layer 12 may be decreased when the density of the second through electrode E232 immediately below the second output extracting electrode E22 is set to be smaller than the density of the first through electrode E231 immediately below the second collecting electrode E21. Thus, the recombination of minority carriers is less likely to occur in the vicinity of the second surface lObs of the semiconductor substrate 10 for example. As a result, the photoelectric conversion efficiency of the solar cell element 1 can be improved.

Therefore, in the first embodiment, the photoelectric conversion efficiency and long-term reliability of the PERC type solar cell element 1 can be improved in a well-balanced manner. Furthermore, for example, the photoelectric conversion efficiency and the long-term reliability may also be improved in a well-balanced manner for the solar cell module 100 in which a plurality of the solar cell elements 1 are arranged.

### <2. Other Embodiments>

The present disclosure is not limited to the first embodiment described above, and various modifications, improvements, and the like may be made without departing from the gist of the present disclosure.

### <2-1. Second Embodiment>

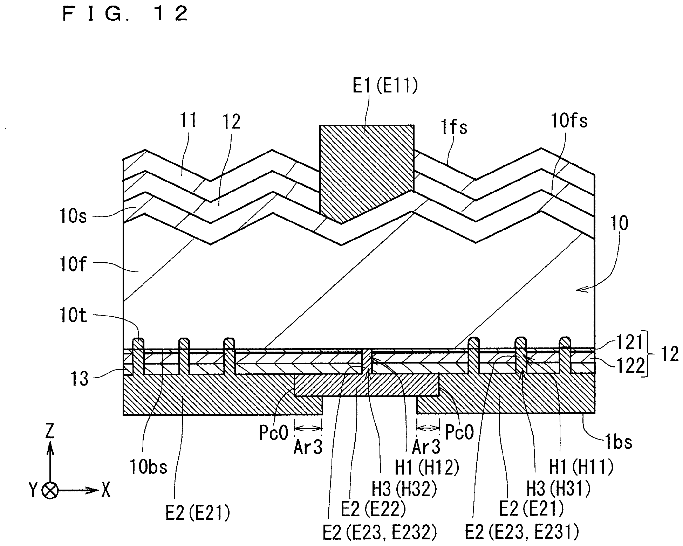

In the first embodiment, for example, the passivation layer 12 is not limited to a single layer. For example, the passivation layer 12 may have a structure in which a plurality of layers are stacked. For example, as shown in Fig. 12, a combination of a plurality of layers includes a combination of a silicon oxide layer 121 positioned on the second surface lObs of the semiconductor substrate 10 and an aluminum oxide layer 122 positioned on the silicon oxide layer 121. In this case, the thickness of the silicon oxide layer 121 is, for example, about 0.1 nm to 5 nm. The thickness of the aluminum oxide layer 122 is, for example, about 5 nm to 30 nm. Here, for example, the passivation layer 12 can be formed by forming the silicon oxide layer 121 on the second surface lObs of the semiconductor substrate 10, and then forming the aluminum oxide layer 122 on the silicon oxide layer 121. The silicon oxide layer 121 and the aluminum oxide layer 122 can be continuously formed by ALD. With the silicon oxide layer 121 thus formed on the p-type first semiconductor region 10f, the dangling bond of the first semiconductor region lOf can be terminated, for example. Thus, in the vicinity of the second surface lObs of the semiconductor substrate 10, recombination of minority carriers generated by photoelectric conversion in response to light irradiation in the semiconductor substrate 10 may be reduced, for example. As a result, the photoelectric conversion efficiency of the solar cell element 1 can further be improved.

### <2-2. Third Embodiment>

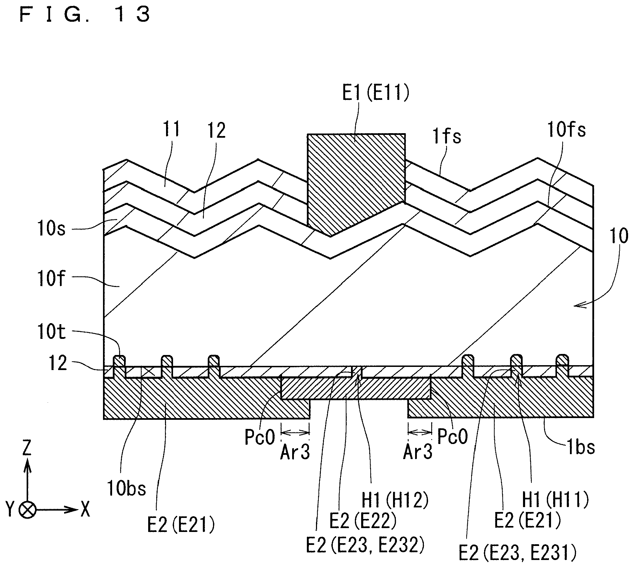

In each of the above embodiments, for example, as shown in Fig. 13, the protective layer 13 may not be present. In other words, for example, the second collecting electrode E21 and the second output extracting electrode E22 may be directly positioned on the passivation layer 12 on the second surface lObs side of the semiconductor substrate 10. In the example in Fig. 13, the first through electrode E231 is positioned in the first A hole H11, and the second through electrode E232 is positioned in the first B hole H12. Such a configuration can be realized, for example, as long as the conductive paste applied on the passivation layer 12 has a component not causing firing through in the passivation layer 12 during firing of the conductive paste.

### <3. Others>

In each of the above embodiments, for example, the second output extracting electrode E22 may contain copper as a main component without containing silver as a main component. In this case, for example, copper paste can be employed instead of the silver paste. For the copper paste, for example, conductive paste containing metal powder containing copper as a main component, an organic vehicle, and glass frits is adopted.

In each of the above embodiments, for example, the second collecting electrode E21 and the second output extracting electrode E22 may be in contact with each other to form the connection region Pc0 without overlapping with each other.

It goes without saying that all or a part of each of the embodiments and various modified examples can be combined as appropriate in a non-contradictory range.

### Explanation of Reference Signs

- 1:: solar cell element

- 10:: semiconductor substrate
- 100:: solar cell module
- 101:: first member
- 102:: filler
- 102b:: second filler
- 102u:: first filler
- 103:: solar cell unit
- 104:: second member
- lObs:: second surface
- 10f:: first semiconductor region
- 10fs:: first surface
- 10s:: second semiconductor region
- 10t:: third semiconductor region
- 11:: antireflection film
- 12:: passivation layer
- 13:: protective layer
- 1bs:: second element surface
- 1fs:: first element surface
- Ar1:: first region
- Ar2:: second region
- Ar3:: overlapping region
- Ar4:: non-connection region
- Cm0:: alloy portion
- E1:: front electrode
- E11:: first output extracting electrode
- E12:: first collecting electrode
- E2:: back electrode
- E21:: second collecting electrode
- E22:: second output extracting electrode
- E23:: through electrode
- E231:: first through electrode
- E232:: second through electrode
- H1:: first hole
- H11:: first A hole
- H12:: first B hole
- H3:: second hole
- H31:: second A hole
- H32:: second B hole
- Pc0:: connection region
- W1:: first wiring member
- W2:: second wiring member

## Claims

1. A solar cell element (1) comprising:
a semiconductor substrate (10) having a first surface (10fs) and a second surface (10bs) positioned opposite to the first surface (10fs);
a passivation layer (12) that is positioned on the second surface (10bs) and has a plurality of holes (H1);
a plurality of through electrodes (E23) that are positioned in the plurality of holes (H1) while being electrically connected to the second surface (10bs) of the semiconductor substrate (10);
a first electrode (E21) that is positioned on the passivation layer (12) while being electrically connected to two or more first through electrodes (E231) in the plurality of through electrodes (E23); and
one or more second electrodes (E22) that are positioned to linearly extend in a first direction (Y) on the passivation layer (12) while being electrically connected to one or more second through electrodes (E232) in the plurality of through electrodes (E23), and are electrically connected to the first electrode (E21); **characterised in that**
when the first electrode (E21) and the second electrode (E22) are seen in plan perspective view, a ratio of an area occupied by the one or more second through electrodes (E232) in a second region (Ar2) in which the second electrode (E22) is positioned is smaller than a ratio of an area occupied by the two or more first through electrodes (E231) in a first region (Ar1) in which the first electrode (E21) is positioned.

2. The solar cell element (1) according to claim 1, wherein
the semiconductor substrate (10) contains silicon,
the first electrode (E21) contains aluminum,
the second electrode (E22) contains silver, and
when the first electrode (E21) and the second electrode (E22) are seen in plan perspective view, the plurality of through electrodes (E23) are not positioned in an overlapping region (Ar3) or in a connection region (Pc0) in the first region (Ar1) and the second region (Ar2), the first region (Ar1) and the second region (Ar2) being in a state of overlapping each other in the overlapping region (Ar3) and in a state of being connected to each other in the connection region (Pc0).

3. The solar cell element (1) according to claim 1 or 2, wherein
the second electrode (E22) has a thickness smaller than a thickness of the first electrode (E21), and
in an overlapping region (Ar3) where the first region (Ar1) and the second region (Ar2) are in the state of overlapping each other, the second electrode (E22) is positioned on the second surface (lObs) and the first electrode (E21) is positioned on the second electrode (E22).

4. The solar cell element (1) according to any one of claims 1 to 3 further comprising a protective layer (13) positioned between the passivation layer (12) and the first electrode (E21) and between the passivation layer (12) and the second electrode (E22).

5. The solar cell element (1) according to claim 4, wherein the protective layer (13) contains silicon nitride.

6. The solar cell element (1) according to any one of claims 1 to 5, wherein
the semiconductor substrate (10) includes a p-type first semiconductor region (10f) positioned on the second surface side and an n-type second semiconductor region (10s) positioned on the first surface side, and
the passivation layer (12) contains aluminum oxide,

7. A solar cell module (100) comprising:
a plurality of the solar cell elements (1) each according to any one of claims 1 to 6, the solar cell elements (1) being positioned to be arranged two dimensionally;
a plurality of wiring members (W1, W2) positioned in a state of electrically connecting adjacent solar cell elements (1) in the plurality of solar cell elements (1);
a first member (101) that is positioned on the first surface side of the plurality of solar cell elements (1) and has translucency;
a second member (104) positioned on the second surface side of the plurality of solar cell elements (1);
a first filler (102u) that is positioned between the plurality of solar cell elements (1) and the first member (101) and has translucency; and
a second filler (102b) that is positioned between the plurality of solar cell elements (1) and the second member (104).

## Patentansprüche

1. Solarzellenelement (1), aufweisend:
ein Halbleitersubstrat (10) mit einer ersten Fläche (10fs) und einer zweiten Fläche (lObs), die gegenüber der ersten Fläche (10fs) positioniert ist,
eine Passivierungsschicht (12), die auf der zweiten Fläche (lObs) positioniert ist und eine Mehrzahl von Löchern (H1) aufweist,
eine Mehrzahl von Durchgangselektroden (E23), die in der Mehrzahl von Löchern (H1) positioniert sind, während sie mit der zweiten Fläche (lObs) des Halbleitersubstrats (10) elektrisch verbunden sind,
eine erste Elektrode (E21), die auf der Passivierungsschicht (12) positioniert ist, während sie mit zwei oder mehr ersten Durchgangselektroden (E231) in der Mehrzahl von Durchgangselektroden (E23) elektrisch verbunden ist, und
eine oder mehrere zweite Elektroden (E22), die positioniert sind, um sich linear in einer ersten Richtung (Y) auf der Passivierungsschicht (12) zu erstrecken, während sie elektrisch mit einer oder mehreren zweiten Durchgangselektroden (E232) in der Mehrzahl von Durchgangselektroden (E23) verbunden sind, und elektrisch mit der ersten Elektrode (E21) verbunden sind, **dadurch gekennzeichnet, dass**,
wenn die erste Elektrode (E21) und die zweite Elektrode (E22) in einer perspektivischen Draufsicht betrachtet werden, ein Verhältnis/Anteil einer Fläche, die von der einen oder den mehreren zweiten Durchgangselektroden (E232) in einem zweiten Bereich (Ar2) eingenommen wird, in dem die zweite Elektrode (F22) positioniert ist, kleiner als ein Verhältnis/Anteil einer Fläche ist, die von den zwei oder mehreren ersten Durchgangselektroden (E231) in einem ersten Bereich (Ar1) eingenommen wird, in dem die erste Elektrode (E21) positioniert ist.

2. Solarzellenelement (1) gemäß Anspruch 1, wobei
das Halbleitersubstrat (10) Silicium enthält,
die erste Elektrode (E21) Aluminium enthält,
die zweite Elektrode (E22) Silber enthält, und
wenn die erste Elektrode (E21) und die zweite Elektrode (E22) in der perspektivischen Draufsicht betrachtet werden, die Mehrzahl von Durchgangselektroden (E23) nicht in einem Überlappungsbereich (Ar3) oder in einem Verbindungsbereich (Pc0) in dem ersten Bereich (Ar1) und dem zweiten Bereich (Ar2) positioniert sind, wobei sich der erste Bereich (Ar1) und der zweite Bereich (Ar2) in einem Zustand, in dem sie einander im Überlappungsbereich (Ar3) überlappen, und in einem Zustand befinden, in dem sie in dem Verbindungsbereich (Pc0) miteinander verbunden sind.

3. Solarzellenelement (1) gemäß Anspruch 1 oder 2, wobei
die zweite Elektrode (E22) eine Dicke hat, die geringer als eine Dicke der ersten Elektrode (E21) ist, und
in einem Überlappungsbereich (Ar3), in dem sich der erste Bereich (Ar1) und der zweite Bereich (Ar2) in dem Zustand befinden, in dem sie einander überlappen, die zweite Elektrode (E22) auf der zweiten Fläche (lObs) positioniert ist und die erste Elektrode (E21) auf der zweiten Elektrode (E22) positioniert ist.

4. Solarzellenelement (1) gemäß irgendeinem der Ansprüche 1 bis 3, ferner aufweisend eine Schutzschicht (13), die zwischen der Passivierungsschicht (12) und der ersten Elektrode (E21) und zwischen der Passivierungsschicht (12) und der zweiten Elektrode (E22) positioniert ist.

5. Solarzellenelement (1) gemäß Anspruch 4, wobei die Schutzschicht (13) Siliciumnitrid enthält.

6. Solarzellenelement (1) gemäß irgendeinem der Ansprüche 1 bis 5, wobei
das Halbleitersubstrat (10) einen auf der Zweite-Fläche-Seite positionierten ersten p-Typ-Halbleiterbereich (10f) und einen auf der Erste-Fläche-Seite positionierten zweiten n-Typ-Halbleiterbereich (10s) aufweist, und
die Passivierungsschicht (12) Aluminiumoxid enthält.

7. Solarzellenmodul (100), aufweisend:
eine Mehrzahl der Solarzellenelemente (1) jeweils gemäß irgendeinem der Ansprüche 1 bis 6, wobei die Solarzellenelemente (1) positioniert sind, um zweidimensional angeordnet zu sein,
eine Mehrzahl von Verdrahtungselementen (W1, W2), die in einem Zustand positioniert sind, in dem sie benachbarte Solarzellenelemente (1) in der Mehrzahl von Solarzellenelementen (1) elektrisch verbinden,
ein erstes Element (101), das auf der Erste-Fläche-Seite der Mehrzahl von Solarzellenelementen (1) positioniert ist und lichtdurchlässig ist,
ein zweites Element (104), das auf der Zweite-Fläche-Seite der Mehrzahl von Solarzellenelementen (1) positioniert ist,
einen ersten Füllstoff (102u), der zwischen der Mehrzahl von Solarzellenelementen (1) und dem ersten Element (102u) positioniert ist und lichtdurchlässig ist, und
einen zweiten Füllstoff (102b), der zwischen der Mehrzahl von Solarzellenelementen (1) und dem zweiten Element (104) positioniert ist.

## Revendications

1. Un élément de cellule solaire (1), comprenant :
un substrat semi-conducteur (10) ayant une première surface (lOfs) et une deuxième surface (lObs) positionnée à l'opposé de la première surface (lOfs),
une couche de passivation (12) positionnée sur la deuxième surface (lObs) et comportant une pluralité de trous (H1),
une pluralité d'électrodes de passage (E23) positionnées dans la pluralité de trous (H1) tout en étant connectées électriquement à la deuxième surface (lObs) du substrat semi-conducteur (10),
une première électrode (E21) positionnée sur la couche de passivation (12) tout en étant connectée électriquement à deux ou plusieurs premières électrodes de passage (E231) dans la pluralité d'électrodes de passage (E23), et
une ou plusieurs deuxièmes électrodes (E22) positionnées pour s'étendre linéairement dans une première direction (Y) sur la couche de passivation (12) tout en étant connectées électriquement à une ou plusieurs deuxièmes électrodes de passage (E232) dans la pluralité d'électrodes de passage (E23), et connectées électriquement à la première électrode (E21), **caractérisé en ce que**,
lorsque la première électrode (E21) et la deuxième électrode (E22) sont considérées dans une vue de dessus en perspective, un rapport d'une surface occupée par les une ou plusieurs deuxièmes électrodes de passage (E232) dans une deuxième région (Ar2), dans laquelle la deuxième électrode (F22) est positionnée, est inférieur à un rapport d'une surface occupée par les deux ou plusieurs premières électrodes de passage (E231) dans une première région (Ar1) dans laquelle la première électrode (E21) est positionnée.

2. L'élément de cellule solaire (1) selon la revendication 1, dans lequel
le substrat semi-conducteur (10) contient du silicium,
la première électrode (E21) contient de l'aluminium,
la deuxième électrode (E22) contient de l'argent, et
lorsque la première électrode (E21) et la deuxième électrode (E22) sont observées dans une vue de dessus en perspective, la pluralité d'électrodes de passage (E23) ne sont pas positionnées dans une région de chevauchement (Ar3) ou dans une région de connexion (Pc0) dans la première région (Ar1) et la deuxième région (Ar2), la première région (Ar1) et la deuxième région (Ar2) étant dans un état dans lequel elles se chevauchent l'une l'autre dans la région de chevauchement (Ar3) et dans un état dans lequel elles sont connectées l'une à l'autre dans la région de connexion (Pc0).

3. L'élément de cellule solaire (1) selon la revendication 1 ou 2, dans lequel
la deuxième électrode (E22) a une épaisseur qui est inférieure à une épaisseur de la première électrode (E21), et
dans une région de chevauchement (Ar3), dans laquelle la première région (Ar1) et la deuxième région (Ar2) sont dans l'état où elles se chevauchent, la deuxième électrode (E22) est positionnée sur la deuxième surface (lObs) et la première électrode (E21) est positionnée sur la deuxième électrode (E22).

4. L'élément de cellule solaire (1) selon l'une quelconque des revendications 1 à 3, comprenant en outre une couche de protection (13) positionnée entre la couche de passivation (12) et la première électrode (E21) et entre la couche de passivation (12) et la deuxième électrode (E22).

5. L'élément de cellule solaire (1) selon la revendication 4, dans lequel la couche de protection (13) contient du nitrure de silicium.

6. L'élément de cellule solaire (1) selon l'une quelconque des revendications 1 à 5, dans lequel
le substrat semi-conducteur (10) comprend une première région semi-conductrice de type p (10f) positionnée sur le côté de deuxième surface et une deuxième région semi-conductrice de type n (10s) positionnée sur le côté de première surface, et
la couche de passivation (12) contient de l'oxyde d'aluminium.

7. Un module de cellules solaires (100), comprenant :
une pluralité des éléments de cellule solaire (1), chacun selon l'une quelconque des revendications 1 à 6, les éléments de cellule solaire (1) étant positionnés de manière à être agencés de façon bidimensionnelle,
une pluralité d'éléments de câblage (W1, W2) positionnés dans un état dans lequel ils connectent électriquement des éléments de cellule solaire (1) adjacents dans la pluralité d'éléments de cellule solaire (1),
un premier élément (101) positionné sur le côté de première surface de la pluralité d'éléments de cellule solaire (1) et étant translucide,
un deuxième élément (104) positionné sur le côté de deuxième surface de la pluralité d'éléments de cellule solaire (1),
un premier matériau de remplissage (102u) positionné entre la pluralité d'éléments de cellule solaire (1) et le premier élément (102u) et étant translucide, et
un deuxième matériau de remplissage (102b) positionné entre la pluralité d'éléments de cellule solaire (1) et le deuxième élément (104).
